# EUROPEAN PATENT SPECIFICATION

(11) **EP 3 839 808 B1**
(45) Date of publication and mention of the grant of the patent: **20.09.2023**
(21) Application number: 19920635.0
(22) Date of filing: 01.11.2019
(51) Int. Cl.: G06V 40/13

(54) **FINGERPRINT DETECTION APPARATUS AND ELECTRONIC DEVICE**
FINGERABDRUCK-ERKENNUNGSGERÄT UND ELEKTRONISCHES GERÄT
APPAREIL DE DÉTECTION D'EMPREINTES DIGITALES ET DISPOSITIF ÉLECTRONIQUE

(43) Date of publication of application: 23.06.2021
(73) Proprietor: SHENZHEN GOODIX TECHNOLOGY CO., LTD., Shenzhen, Guangdong 518045 (CN)
(72) Inventor: ZHANG, Sichao, Guangdong 518045 (CN); LIN, Junxian, Guangdong 518045 (CN); WANG, Yin, Guangdong 518045 (CN); TSAI, Fei Hsin, Guangdong 518045 (CN)
(74) Representative: Pfenning, Meinig & Partner mbB
(86) International application number: PCT/CN2019/115162
(87) International publication number: WO 2021/082017

(56) References cited:
- CN-A- 109 863 506
- CN-A- 110 062 931
- US-A1- 2016 254 312
- US-A1- 2019 026 523
- US-B2- 7 834 988

## Description

### TECHNICAL FIELD

Embodiments of the present application relate to the field of fingerprint detection, and more particularly, to a fingerprint detection apparatus and an electronic device.

### BACKGROUND

Due to increasing miniaturization of future handheld electronic products, the current lens-type under-screen optical fingerprint product is difficult to adapt to this trend in size, and there is an urgent need to develop toward thinner thickness, smaller volume, and higher integration. However, in the currently existing miniaturization scheme, contrast of an image imaged using collimating holes is related to a depth of the collimating holes, a relatively great depth is required to achieve a higher imaging quality, and light utilization of this scheme is low. A scheme of using micro lens focusing is limited by processes and a shape of a lens surface. Although the light utilization is higher, a light path design is more complicated and lacks normative design parameters such that aliasing easily occurs for light signals at different positions, resulting in low contrast of the signals and a low imaging quality of a fingerprint.

US2019/026523A1 provides a device for optical sensing, comprising: a display comprising a transparent substrate and a plurality of light emitters disposed above the transparent substrate; a transparent cover layer disposed above the display, wherein a top surface of the transparent cover layer provides an input surface for sensing an input object; and an angled filter disposed below the transparent substrate of the display, wherein the angled filter is configured to allow light within a tolerance angle of an acceptance angle to pass through the angled filter, wherein the acceptance angle is centered around a non-zero angle relative to a normal of the input surface.

### SUMMARY

Embodiments of the present application provide a fingerprint detection apparatus and an electronic device. By restricting structure parameters of small holes in an array of small holes, aliasing of transmission of light signals returned via different positions of a finger could be avoided. That is, on the basis of a guarantee of contrast of a fingerprint image, brightness of the fingerprint image is improved, a signal-to-noise ratio and a resolution of the fingerprint image are increased, and a fingerprint identification effect and identification accuracy are improved.

In a first aspect, a fingerprint detection apparatus is provided, where the fingerprint detection apparatus is applied below a display screen to implement under-screen optical fingerprint detection, and the fingerprint detection apparatus includes: a micro lens array disposed below the display screen, wherein the micro lens array comprises a rectangular array of 2×2 micro lenses, the plurality of optical sensing pixels are a rectangular array of 2×2 optical sensing pixels, and one micro lens is disposed right above each optical sensing pixel in the rectangular array of 2×2 optical sensing pixel, wherein the micro lens at the upper right corner of the array converges the received oblique light signals to the optical sensing pixel at the upper left corner, the micro lens at the upper left corner of the array converges the received oblique light signals to the optical sensing pixel at the lower left corner, the micro lens at the lower left corner of the array converges the received oblique light signals to the optical sensing pixel at the lower right corner, and the micro lens at the lower right corner of the array converges the received oblique light signals to the optical sensing pixel at the upper right corner;
Z light shielding layers disposed below the micro lens array, each of the Z light shielding layers being provided with an array of small holes, where Z is a positive integer; and
an optical sensing pixel array disposed below an array of small holes of a bottom light shielding layer of the Z light shielding layers;
where the array of small holes of each of the Z light shielding layers satisfies 0 ≤ *Xᵢ* / *Z_{d}* ≤ 3, such that a light signal returned from a finger above the display screen is transmitted to the optical sensing pixel array through arrays of small holes provided in the Z light shielding layers after being converged by the micro lens array, and the light signal is used to detect fingerprint information of the finger;
*Z_{d}* represents a vertical distance between the bottom light shielding layer and the micro lens array, *Xᵢ* represents a distance between projections of a first center and a second center on a plane where the micro lens array is located, the first center is a center of a micro lens in the micro lens array, and the second center is a center of a small hole in the i-th light shielding layer of the Z light shielding layers for transmitting a light signal converged by the micro lens;
the Z light shielding layers satisfy 0 ≤ *Zᵢ* / *Z_{d}* ≤ 1, where *Zᵢ* represents a vertical distance between the i-th light shielding layer of the Z light shielding layers and the micro lens array; and
a metal wiring layer of the optical sensing pixel array is disposed at a position of a back focal plane of the micro lens array, and the metal wiring layer is provided with one opening formed above each optical sensing pixel in the optical sensing pixel array to form the bottom light shielding layer, a small hole in the array of small holes of the bottom light shielding layer satisfies 0*um* < *D_{d}* ≤ 6*um*, wherein *D_{d}* represents a maximum aperture of the small hole in the array of small holes of the bottom light shielding layer.

By restricting structure parameters of small holes in an array of small holes, aliasing of transmission of light signals returned via different positions of a finger could be avoided. That is, on the basis of a guarantee of contrast of a fingerprint image, brightness of the fingerprint image is improved, a signal-to-noise ratio and a resolution of the fingerprint image are increased, and a fingerprint identification effect and identification accuracy are improved.

In some possible implementation manners, the array of small holes of each of the Z light shielding layers satisfies 0 ≤ *Xᵢ* / *Z_{d}* ≤ 3/2.

For a fingerprint image acquired through small hole imaging, the greater the contrast of the image is, the less the brightness (that is, an amount of light passing through a small hole) is. Correspondingly, the greater the brightness is, the less the contrast of the image is. In this embodiment, by restricting a maximum aperture of a small hole in an array of small holes, it can not only be guaranteed that each optical sensing pixel in an optical sensing pixel array can receive sufficient light signals, but also be guaranteed that an imaged image has sufficient brightness.

In some possible implementation manners, the metal wiring layer of the optical sensing pixel array is disposed at a position of a back focal plane of the micro lens array, the small hole in the array of small holes of the bottom light shielding layer satisfies 0.5*um* < *D_{d}* ≤ 5*um.*

When a fingerprint image is acquired through small hole imaging, it is necessary to guarantee that a spherical aberration of a micro lens in an micro lens array does not affect imaging quality. In this embodiment, by restricting a ratio of a maximum thickness of a micro lens to a maximum caliber of the micro lens, on the basis of miniaturization of a fingerprint detection apparatus, it can be guaranteed that the micro lens focuses a converged light signal in a small hole of a bottom light shielding layer, thereby guaranteeing imaging quality of a fingerprint image. In other words, by restricting a ratio of *H* to *C* , on the basis of a guarantee that a fingerprint detection apparatus is thinner in thickness, a spherical aberration of the micro lens array is reduced, thereby guaranteeing a fingerprint identification effect.

In some possible implementation manners, each micro lens in the micro lens array satisfies 0 *< H* / *C* ≤ 1/2 .

In some possible implementation manners, the bottom light shielding layer and the micro lens array satisfy 0*um* ≤ *Z_{d}* ≤ 100*um*.

In some possible implementation manners, the bottom light shielding layer and the micro lens array satisfy 2*um* ≤ *Z_{d}* ≤ 50*um.*

In some possible implementation manners, the micro lens array satisfies 0*um < P* ≤ *100um* , and *P* represents a period of a micro lens in the micro lens array.

In some possible implementation manners, the micro lens array satisfies 2*um* ≤ *P* ≤ 50*um.*

In some possible implementation manners, a small hole in the array of small holes of each of the Z light shielding layers and a micro lens in the micro lens array satisfy 0 < *Dᵢ* / *P* ≤ 3, where *Dᵢ* represents an aperture of a small hole in an array of small holes of the i-th light shielding layer of the Z light shielding layers, and *P* represents a period of the micro lens in the micro lens array.

In some possible implementation manners, the small hole in the array of small holes of each of the Z light shielding layers and the micro lens in the micro lens array satisfy 0 *< Dᵢ* / *P* ≤ 2.

By restricting a ratio of *C* to *P ,* a duty cycle of a micro lens array can be increased, thereby guaranteeing that the fingerprint detection apparatus is smaller in volume.

In some possible implementation manners, the Z light shielding layers are a plurality of light shielding layers.

In some possible implementation manners, one opening in an array of small holes of a top light shielding layer of the plurality of light shielding layers corresponds to a plurality of optical sensing pixels in the optical sensing pixel array.

In some possible implementation manners, the fingerprint detection apparatus further includes:
a transparent medium layer;
where the transparent medium layer is used to connect the micro lens array, the Z light shielding layers and the optical sensing pixel array.

In some possible implementation manners, the fingerprint detection apparatus further includes:
a filter layer;
where the filter layer is disposed in a light path between the micro lens array and the optical sensing pixel array or disposed above the micro lens array, and the filter layer is used to filter out a light signal in a non-target wave band to transmit a light signal in a target wave band.

In a second aspect, an electronic device is provided, including:
a display screen; and the fingerprint detection apparatus in the first aspect or in any possible implementation manner in the first aspect, where the apparatus is disposed below the display screen to implement under-screen optical fingerprint detection.

### BRIEF DESCRIPTION OF DRAWINGS

FIG. 1 is a schematic structural diagram of an electronic device to which the present application is applicable.
FIG. 2 is a schematic cross-sectional view of the electronic device shown in FIG 1.
FIG. 3 is another schematic structural diagram of an electronic device to which the present application is applicable.
FIG. 4 is a schematic cross-sectional view of the electronic device shown in FIG 3.
FIG. 5 to FIG. 29 are schematic structural diagrams of a fingerprint detecting unit according to an embodiment of the present application.
FIG. 30 is a schematic top view of a fingerprint detection apparatus according to an embodiment of the present application.
FIG. 31 is a schematic side cross-sectional view of the fingerprint detection apparatus shown in FIG. 30 in a B-B' direction.
FIG. 32 is a schematic structural diagram of structure parameters in a fingerprint detection apparatus according to an embodiment of the present application.
FIG. 33 and FIG. 34 each are schematic top views of the fingerprint detection apparatus shown in FIG. 32.

### DESCRIPTION OF EMBODIMENTS

The technical solutions in embodiments of the present application will be described hereinafter with reference to the accompanying drawings.

The technical solutions of the embodiments of the present application may be applied to various electronic devices. For example, portable or mobile computing devices such as smartphones, laptops, tablets and gaming devices, and other electronic devices such as electronic databases, automobiles and bank automated teller machines (ATM), which are not limited in the embodiments of the present application.

The technical solutions of the embodiments of the present application may be applied to a biometric identification technology. The biometric identification technology includes, but is not limited to, identification technologies, such as fingerprint identification, palm print identification, iris identification, human face identification and living body identification. For convenience of illustration, a fingerprint identification technology is described below as an example.

The technical solutions of the embodiments of the present application may be used for an under-screen fingerprint identification technology and an in-screen fingerprint identification technology.

The under-screen fingerprint identification technology refers to mounting a fingerprint identification module under a display screen, so as to realize a fingerprint identification operation in a display region of the display screen without setting a fingerprint capturing region in a region other than the display region on a front face of an electronic device. Specifically, the fingerprint identification module uses light returned from a top surface of a display component of the electronic device for fingerprint sensing and other sensing operations. This returned light carries information about an object (for example, a finger) that is in contact with or near the top surface of the display component, and the fingerprint identification module located under the display component implements under-screen fingerprint identification by capturing and detecting this returned light. The fingerprint identification module may be designed to achieve desired optical imaging by properly configuring an optical element for capturing and detecting returned light so that fingerprint information of the finger is detected.

Correspondingly, the in-screen fingerprint identification technology refers to mounting a fingerprint identification module or a part of a fingerprint identification module inside a display screen, so as to realize a fingerprint identification operation in a display region of the display screen without setting a fingerprint capturing region in a region other than the display region on a front face of an electronic device.

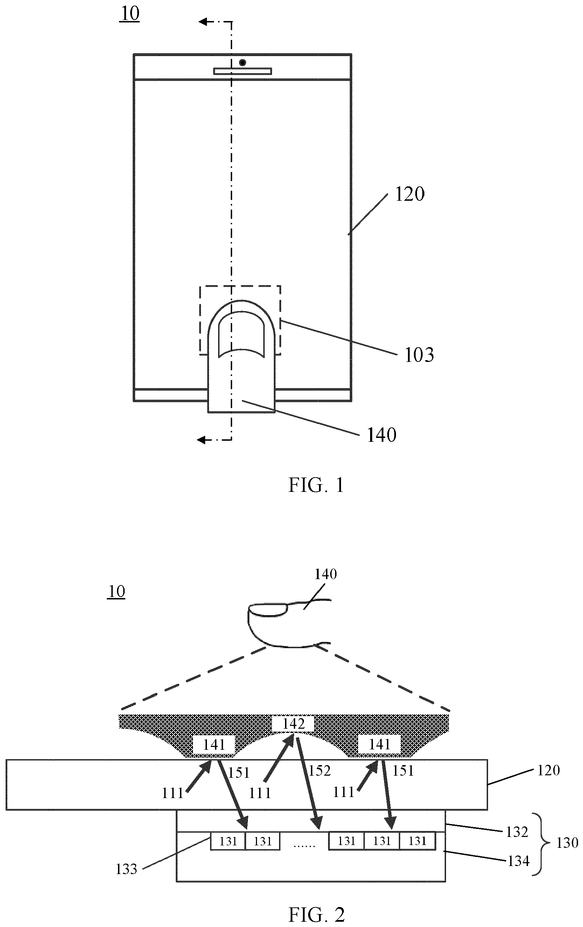

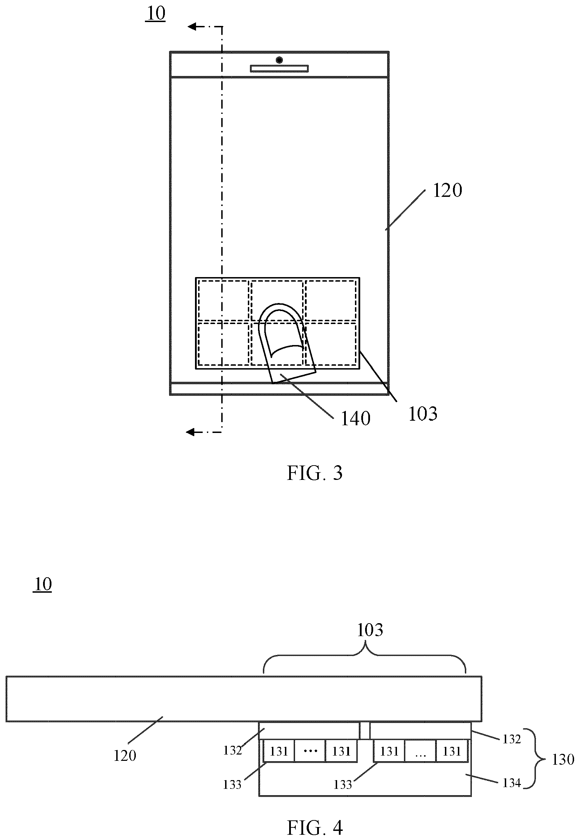

FIG. 1 to FIG. 4 illustrate schematic diagrams of an electronic device to which the present application is applicable. FIG. 1 and FIG. 3 are schematic oriented diagrams of an electronic device 10; and FIG. 2 and FIG. 4 are schematic cross-sectional views of the electronic device 10 shown in FIG 1 and FIG. 3, respectively.

With reference to FIG. 1 to FIG. 4, the electronic device 10 may include a display screen 120 and an optical fingerprint identification module 130.

The display screen 120 may be a self-light-emitting display screen that adopts a self-light-emitting display unit as a display pixel. For example, the display screen 120 may be an organic light-emitting diode (OLED) display screen or a micro light-emitting diode (Micro-LED) display screen. In other alternative embodiments, the display screen 120 may also be a liquid crystal display (LCD) screen or other passive light-emitting display screens, which is not limited in the embodiments of the present application. Further, the display screen 120 may specifically be a touch display screen, which may not only display an image, but also detect a touch or press operation of a user, thereby providing the user with a human-machine interaction interface. For example, in an embodiment, the electronic device 10 may include a touch sensor, and the touch sensor may specifically be a touch panel (TP), which may be disposed on a surface of the display screen 120, or may be partially integrated or entirely integrated into an interior of the display screen 120 to form the touch display screen.

The optical fingerprint module 130 includes an optical fingerprint sensor that includes a sensing array 133 having a plurality of optical sensing units 131 (which may also be referred to as optical sensing pixels, photosensitive pixels, pixel units, or the like). A region where the sensing array 133 is located or a sensing region of the sensing array 133 is a fingerprint detecting region 103 (which is also referred to as a fingerprint capturing region, a fingerprint identification region, or the like) of the optical fingerprint module 130. For example, the optical sensing units 131 may be photo detectors, that is, the sensing array 133 may specifically be a photo detector array including a plurality of photo detectors distributed in an array.

The optical fingerprint module 130 is disposed in a partial region under the display screen 120.

With continuing reference to FIG. 1, the fingerprint detecting region 103 may be located in a display region of the display screen 120. In an alternative embodiment, the optical fingerprint module 130 may also be disposed at another position, such as a side of the display screen 120 or an non-light-transmitting region of an edge of the electronic device 10, and a light signal from at least part of the display region of the display screen 120 is directed to the optical fingerprint module 130 through a light path design, such that the fingerprint detecting region 103 is actually located in the display region of the display screen 120.

For the electronic device 10, when a user needs to unlock the electronic device 10 or perform other fingerprint verification, a fingerprint input can be implemented merely by pressing a finger against the fingerprint detecting region 103 in the display screen 120. Since fingerprint detection can be implemented in the screen, there is no need to reserve space for a front face of the electronic device 10 in the foregoing structure to set a fingerprint button (such as a Home button), so that a full screen scheme can be adopted; that is, the display region of the display screen 120 can be substantially extended to the entire front face of the electronic device 10.

With continuing reference to FIG. 2, the optical fingerprint module 130 may include a light detecting portion 134 and an optical component 132. The light detecting portion 134 includes the sensing array 133 (which may also be referred to as an optical fingerprint sensor), a readout circuit and other auxiliary circuits electrically connected to the sensing array 133, and may be fabricated on a die by a semiconductor process, such as an optical imaging chip or an optical fingerprint sensor. The optical component 132 may be disposed above the sensing array 133 of the light detecting portion 134, and may specifically include a filter layer, a light directing layer or a light path directing structure, and other optical elements. The filter layer may be used to filter out ambient light penetrating a finger, and the light directing layer or light path directing structure is mainly used to direct reflected light reflected from a finger surface to the sensing array 133 for optical detection.

In some embodiments of the present application, the optical component 132 and the light detecting portion 134 may be encapsulated in the same optical fingerprint member. For example, the optical component 132 and the optical detecting portion 134 may be encapsulated in the same optical fingerprint chip, or the optical component 132 may be disposed outside a chip where the optical detecting portion 134 is located, for example, the optical component 132 is attached above the chip, or some elements of the optical component 132 are integrated into the foregoing chip.

In some embodiments of the present application, a region where the sensing array 133 of the optical fingerprint module 130 is located or an optical sensing range of the sensing array 133 of the optical fingerprint module 130 corresponds to the fingerprint detecting region 103 of the optical fingerprint module 130. An area of the fingerprint capturing region 103 of the optical fingerprint module 130 may be equal to or not equal to an area of the region where the sensing array 133 of the optical fingerprint module 130 is located or the optical sensing range of the sensing array 133 of the optical fingerprint module 130, which is not specifically limited in the embodiment of the present application.

For example, a light path is directed by means of light collimation, and the area of the fingerprint detecting region 103 of the optical fingerprint module 130 may be designed to be substantially identical with the area of the sensing array of the optical fingerprint module 130.

For another example, the area of the fingerprint detecting region 103 of the optical fingerprint module 130 may be larger than the area of the sensing array 133 of the optical fingerprint module 130 through for example, a lens imaging light path design, a reflective folding light path design or other light path designs such as light convergence or reflection.

A light path directing structure that the optical component 132 may include will be exemplarily described below.

In an example that the light path directing structure adopts an optical collimator having an array of through holes with a high aspect ratio, the optical collimator may specifically be a collimator layer fabricated on a semiconductor silicon wafer, which has a plurality of collimating units or micro holes, and the collimating units may specifically be small holes. Among reflected light reflected back from a finger, light that is vertically incident to the collimating unit may pass through the collimating unit and be received by a sensor chip under the collimating unit, and light with an overlarge incident angle is attenuated through multiple reflections inside the collimating unit. Therefore, each sensor chip may basically only receive reflected light reflected back from a fingerprint pattern right above the sensor chip, which could effectively improve an image resolution and then improve a fingerprint identification effect.

In an example that the light path directing structure adopts a light path design of an optical lens, the light path directing structure may be an optical lens layer having one or more lens units, for example, a lens group composed of one or more aspheric lenses, for converging reflected light reflected back from a finger to the sensing array 133 of the light detecting portion 134 under the optical lens layer, such that the sensing array 133 may perform imaging based on the reflected light so as to obtain a fingerprint image of the finger. Further, the optical lens layer may further be provided with a pinhole or a micro hole diaphragm formed in a light path of the lens unit. For example, one or more light blocking sheets may be provided in the light path of the lens unit, where at least one light blocking sheet may be provided with a light-transmitting micro hole formed in an optical axis or an optical center area of the lens unit, and the light-transmitting micro hole may serve as the foregoing pinhole or micro hole diaphragm. The pinhole or micro hole diaphragm may cooperate with the optical lens layer and/or another optical film layers above the optical lens layer and expand the field of view of the optical fingerprint module 130 to improve a fingerprint imaging effect of the optical fingerprint module 130.

In an example that the light path directing structure adopts a light path design of a micro lens layer, the light path directing structure may be a micro lens array formed by a plurality of micro lenses, which may be provided above the sensing array 133 of the light detecting portion 134 by a semiconductor growth process or other processes, and each micro lens may correspond to one of the sensing units in the sensing array 133. Moreover, another optical film layer such as a medium layer or a passivation layer may be provided between the micro lens layer and the sensing units. More specifically, a light shielding layer (or referred to as a light blocking layer, a light resisting layer, or the like) having micro holes (or referred to as openings) may further be provided between the micro lens layer and the sensing units, where a micro hole is provided between a corresponding micro lens and a corresponding sensing unit, and the light shielding layer may shield optical interference between adjacent micro lenses and sensing units such that light corresponding to the sensing unit is converged to an interior of the micro hole through the micro lens and transmitted to the sensing unit via the micro hole to perform optical fingerprint imaging.

It should be understood that the forgoing several implementations for a light path directing structure may be used alone or in combination.

A micro lens layer is disposed above the collimator layer or the optical lens layer. Certainly, when the collimator layer or the optical lens layer is used in combination with the micro lens layer, the specific laminated structure or light path may require to be adjusted according to actual needs.

On the other hand, the optical component 132 may further include other optical elements, for example, a filter layer or other optical films, which may be disposed between the light path directing structure and the optical fingerprint sensor or between the display screen 120 and the light path directing structure, and are mainly used to isolate the impact of external interference light on optical fingerprint detection. The filter layer may be used to filter out ambient light that penetrates a finger and enters into the optical fingerprint sensor via the display screen 120. Similar to the light path directing structure, the filter layer may be respectively configured for each optical fingerprint sensor to filter out interference light, or a filter layer with a large area may be adopted to cover a plurality of optical fingerprint sensors simultaneously.

The fingerprint identification module 130 may be used for capturing fingerprint information (such as fingerprint image information) of a user.

The following is described by an example that the display screen 120 adopts a display screen with a self-light-emitting display unit, for example, an organic light-emitting diode (OLED) display screen or a micro light-emitting diode (Micro-LED) display screen, the optical fingerprint module 130 may use a display unit (that is, an OLED light source) of the OLED display screen 120 located in the fingerprint detecting region 103 as an excitation light source for optical fingerprint detection. When a finger 140 is pressed against the fingerprint detecting region 103, the display screen 120 emits a beam of light 111 to the target finger 140 above the fingerprint detecting region 103, and the light 111 is reflected by a surface of the finger 140 to form reflected light or scattered inside the finger 140 to form scattered light (transmissive light). In related patent applications, the foregoing reflected light and scattered light are collectively referred to as reflected light for convenience of description. Since a ridge 141 and a valley 142 of a fingerprint have different light reflecting capabilities, reflected light 151 from the ridge of the fingerprint and reflected light 152 from the valley of the fingerprint have different light intensities. After passing through the optical component 132, the reflected light is received by the sensing array 133 in the optical fingerprint module 130 and converted into a corresponding electrical signal, that is, a fingerprint detecting signal; and fingerprint image data may be obtained based on the fingerprint detecting signal, and fingerprint matching verification may be further performed, thereby implementing an optical fingerprint identification function in the electronic device 10.

In other alternative solutions, the optical fingerprint module 130 may also use an internal light source or an external light source to provide a light signal for fingerprint detection and identification. In this case, the optical fingerprint module 130 can not only apply to a self-light-emitting display screen such as an OLED display screen, but also apply to a non-self-light-emitting display screen such as a liquid crystal display screen or another passive light-emitting display screen.

In an example of a liquid crystal display screen having a backlight module and a liquid crystal panel, in order to support under-screen fingerprint detection of the liquid crystal display screen, an optical fingerprint system of the electronic device 10 may further include an excitation light source for optical fingerprint detection. The excitation light source may specifically be an infrared light source or a light source of non-visible light at a specific wavelength, which may be disposed under the backlight module of the liquid crystal display screen or disposed in an edge area under a protective cover of the electronic device 10. The optical fingerprint module 130 may be disposed under the liquid crystal panel or an edge area of the protective cover, and by being directed over a light path, light for fingerprint detection may reach the optical fingerprint module 130. Alternatively, the optical fingerprint module 130 may also be disposed under the backlight module, and the backlight module allows the light for fingerprint detection to pass through the liquid crystal panel and the backlight module and reach the optical fingerprint module 130 by providing an opening on film layers such as a diffusion sheet, a brightening sheet, a reflection sheet or the like, or by performing other optical designs. When the optical fingerprint module 130 provides a light signal for fingerprint detection by adopting an internal light source or an external light source, a detection principle is consistent with the foregoing description.

In a specific implementation, the electronic device 10 may further include a transparent protective cover; and the cover may be a glass cover or a sapphire cover which is located above the display screen 120 and covers a front face of the electronic device 10. Therefore, in an embodiment of the present application, the so-called finger being pressed against the display screen 120 actually refers to the finger being pressed against the cover above the display screen 120 or a surface of a protective layer covering the cover.

On the other hand, the optical fingerprint module 130 may only include one optical fingerprint sensor, and in this case, the fingerprint detecting region 103 of the optical fingerprint module 130 has a smaller area and a fixed position, and therefore, when an fingerprint input is performed, the user needs to press the finger at a specific position of the fingerprint detecting region 103, otherwise the optical fingerprint module 130 may not be able to capture the fingerprint image, thereby resulting in poor user experience. In other alternative embodiments, the optical fingerprint module 130 may specifically include a plurality of optical fingerprint sensors. The plurality of optical fingerprint sensors may be disposed under the display screen 120 side by side in a splicing manner, and sensing regions of the plurality of optical fingerprint sensors collectively constitute the fingerprint detecting region 103 of the optical fingerprint module 130. Thus the fingerprint detecting region 103 of the optical fingerprint module 130 may extend to a main region of a lower half part of the display screen, that is, to a region generally pressed against by the finger, thereby implementing a blind pressing type of fingerprint input operation. Further, when the number of the optical fingerprint sensors is sufficient, the fingerprint detecting region 103 may also extend to a half of the display region or even the entire display region, thereby achieving half-screen or full-screen fingerprint detection.

With reference to FIG. 3 and FIG. 4, an optical fingerprint module 130 in the electronic device 10 may include a plurality of optical fingerprint sensors, the plurality of optical fingerprint sensors may be disposed under a display screen 120 side by side in a splicing manner or the like for example, and sensing regions of the plurality of optical fingerprint sensors collectively constitute a fingerprint detecting region 103 of the optical fingerprint module 130.

Further, the optical component 132 may include a plurality of light path directing structures, and each light path directing structure respectively corresponds to one optical fingerprint sensor (that is, a sensing array 133) and is respectively attached above a corresponding optical fingerprint sensor. Alternatively, the plurality of optical fingerprint sensors may also share an entire light path directing structure, that is, the light path directing structure has an area large enough to cover sensing arrays of the plurality of optical fingerprint sensors.

In an example that the optical component 132 adopts an optical collimator having an array of through holes with a high aspect ratio, when the optical fingerprint module 130 includes a plurality of optical fingerprint sensors, one or more collimating units may be configured for one optical sensing unit in an optical sensing array of each optical fingerprint sensor, and attached above a corresponding optical sensing unit. Certainly, a plurality of optical sensing units may also share one collimating unit, that is, the one collimating unit has a sufficiently large aperture to cover the plurality of optical sensing units. Since one collimating unit may correspond to a plurality of optical sensing units or one optical sensing unit corresponds to a plurality of collimating units, and a correspondence between a spatial period of the display screen 120 and a spatial period of the optical fingerprint sensors is broken, even if a spatial structure of a light-emitting display array of the display screen 120 and a spatial structure of the optical sensing array of the optical fingerprint sensor are similar, it could be effectively avoided that the optical fingerprint module 130 uses a light signal passing through the display screen 120 to perform fingerprint imaging to generate Moire fringes, and the fingerprint identification effect of the optical fingerprint module 140 is effectively improved.

In an example that the optical component 132 adopts an optical lens, when the optical fingerprint module 130 includes a plurality of sensor chips, one optical lens may be configured for each of the sensor chips for fingerprint imaging, or one optical lens may be configured for the plurality of sensor chips to realize light convergence and fingerprint imaging. Even when one sensor chip has dual sensing arrays (Dual-Array) or multiple sensing arrays (Multi-Array), two or more optical lenses may be configured for this sensor chip to cooperate with the dual sensing arrays or the multiple sensing arrays for optical imaging, so as to reduce an imaging distance and enhance the imaging effect.

It should be understood that FIGs. 1 to 4 are only examples of the present application and should not be understood as limitation to the present application.

For example, the present application does not specifically limit the number, size, and arrangement of the fingerprint sensors, which can be adjusted according to actual needs. For example, the optical fingerprint module 130 may include a plurality of fingerprint sensors distributed in a square or a circle.

It should be noted that, assuming that an optical directing structure that the optical component 132 includes is an optical collimator or a micro lens array, the effective field of view of the sensing array 133 of the optical fingerprint module 130 is limited by an area of the optical component. In an example of a micro lens array, in a general design, the micro lens array is located right above or obliquely above the sensing array 133, and one micro lens corresponds to one optical sensing unit, that is, each micro lens in the micro lens array focuses received light on an optical sensing unit corresponding to the same micro lens. Therefore, the fingerprint identification region of the sensing array 133 is affected by the size of the micro lens array.

Therefore, how to improve a region for fingerprint identification has become an urgent technical problem to be solved.

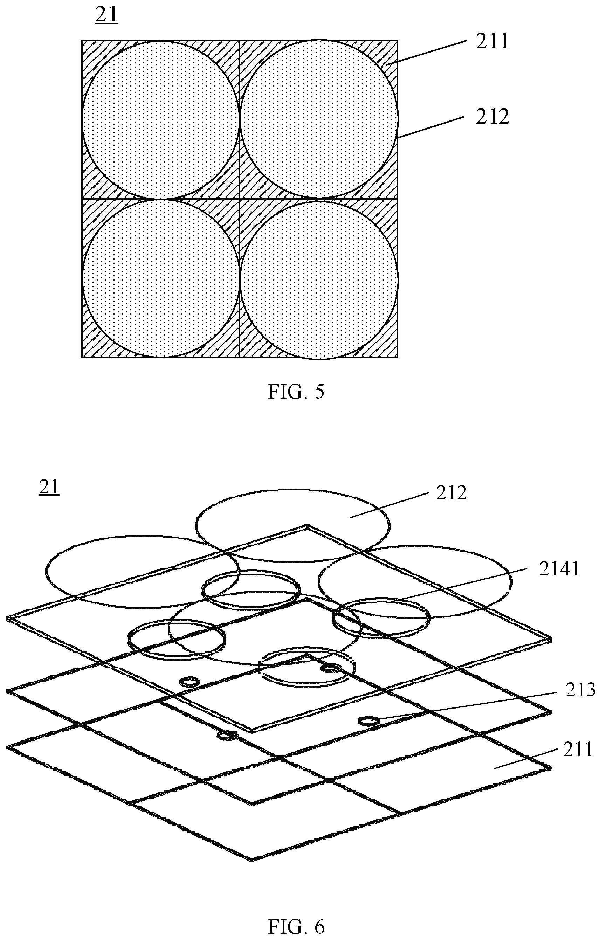

A fingerprint detection apparatus according to the embodiments of the present application is applied below a display screen to implement under-screen optical fingerprint detection. The fingerprint detection apparatus may be applicable to the electronic device 10 shown in FIG. 1 to FIG. 4, or the apparatus may be the optical fingerprint module 130 shown in FIG. 2 or FIG. 4. For example, the fingerprint detection apparatus includes a plurality of fingerprint detecting units 21 as shown in FIG. 5.

It should be understood that the fingerprint detection apparatus may include a plurality of fingerprint detecting units distributed in an array or arranged in a staggered manner, or may include a plurality of fingerprint detecting units distributed in a central symmetric or axisymmetric manner, which is not specifically limited in the embodiment of the present application. For example, the fingerprint detection apparatus may include a plurality of fingerprint detecting units that are disposed independently in structure but arranged in a staggered manner in arrangement. For example, two adjacent columns or two adjacent rows of fingerprint detecting units in the fingerprint detection apparatus are arranged in a staggered manner. Certainly, the fingerprint detection apparatus may also include a plurality of fingerprint detecting units staggered with each other in structure. For example, a micro lens in each fingerprint detecting unit in the fingerprint detection apparatus may converge a received oblique light signal to optical sensing pixels under adjacent micro lenses in the plurality of fingerprint detecting units. In other words, each micro lens converges a received oblique light signal to optical sensing pixels under a plurality of micro lenses adjacent to the same micro lens.

Each of the plurality of fingerprint detecting units includes a plurality of optical sensing pixels, at least one micro lens and at least one light shielding layer.

In a specific implementation, the at least one micro lens may be disposed above the plurality of optical sensing pixels, or the plurality of optical sensing pixels may be disposed below a plurality of micro lenses adjacent to the at least one micro lens, respectively; and the at least one light shielding layer may be provided between the at least one micro lens and the plurality of optical sensing pixels, and each of the at least one light shielding layer is provided with openings corresponding to the plurality of optical sensing pixels. Oblique light signals in multiple directions returned from a finger above the display screen are respectively transmitted to the plurality of optical sensing pixels through the openings provided in the at least one light shielding layer after being converged by the at least one micro lens, and the oblique light signals are used to detect fingerprint information of the finger.

The oblique light signals in multiple directions received by the at least one micro lens may be incident directions of oblique light with respect to the at least one micro lens. For example, the at least one micro lens may be regarded as a whole; and in this case, in a top view, the multiple directions may be light signals from four directions of up, down, left and right received by the at least one micro lens, and angles of the oblique light signals in these four directions with respect to a plane where the display screen is located may be the same or different. The multiple directions may be directions with respect to the plane where the display screen is located, or directions with respect to three-dimensional space. The multiple directions may be different from each other, or may be partially different.

The micro lens may be various lenses with a convergence function for increasing a field of view and increasing an amount of light signals transmitted to photosensitive pixels. A material of the micro lens may be an organic material such as resin.

The optical sensing pixel may be a photoelectric sensor configured to convert a light signal into an electrical signal. Optionally, the optical sensing pixel may adopt a complementary metal oxide semiconductor (CMOS) device, that is, a semiconductor device composed of a PN junction, and has a unidirectional conductive characteristic. Optionally, the optical sensing pixel has a light sensitivity greater than a first predetermined threshold and quantum efficiency greater than a second predetermined threshold for blue light, green light, red light, or infrared light. For example, the first predetermined threshold may be 0.5 v/lux-sec and the second predetermined threshold may be 40%. That is, the photosensitive pixel has a higher light sensitivity and higher quantum efficiency for blue light (at a wavelength of 460±30 nm), green light (at a wavelength of 540±30 nm), red light or infrared light (at a wavelength greater than or equal to 610 nm) to facilitate detection of corresponding light.

It should be noted that the embodiment of the present application does not limit the specific shapes of the micro lens and the optical sensing pixel. For example, each of the plurality of optical sensing pixels may be a polygonal pixel such as a quadrilateral or hexagonal pixel, or may be a pixel in another shape, such as a circular pixel, such that the plurality of optical sensing pixels have higher symmetry, higher sampling efficiency, equidistant adjacent pixels, a better angular resolution, and less aliasing effect. In addition, the foregoing parameters for the optical sensing pixels may correspond to light required for fingerprint detection. For example, if the light required for fingerprint detection is only light in a wave band, the foregoing parameters for the photosensitive pixels only need to meet requirements of the light in this wave band.

Signals received by the plurality of optical sensing pixels are oblique light signals in multiple directions, that is, light signals in multiple directions obliquely incident.

When contact between a fingerprint of a dry finger and an OLED screen is bad, contrast of a fingerprint image between a fingerprint ridge and a fingerprint valley in a vertical direction is poor, and the image is too blurred to distinguish the fingerprint pattern. The present application could detect a fingerprint image of the dry finger better while normal finger fingerprints can be acquired better by using a reasonable light path design to allow a light path to receive oblique light signals. In a normal life scene, for example, in a scene such as after washing hands, getting up in the morning, wiping dust with a finger, or at a low temperature, the finger is usually dry, the cuticle is uneven, and when the finger is pressed against the OLED screen, poor contact may occur in some regions of the finger. The occurrence of this case causes a bad effect of the current optical fingerprint solution on fingerprint identification for a dry hand, and the beneficial effect of the present application is to improve a fingerprint imaging effect of a dry hand and make a fingerprint image of the dry hand clear.

In addition, by performing non-directly facing light imaging (that is, oblique light imaging) on the oblique light signals in multiple directions by the at least one micro lens, a thickness of a light path design layer between the at least one micro lens and the optical sensing pixel array can be shortened, thereby reducing the thickness of the fingerprint detection apparatus effectively.

Meanwhile, by imaging the oblique light signals in multiple directions, an object space numerical aperture of an optical system can be expanded, thereby improving robustness and tolerance of the fingerprint detection apparatus. The numerical aperture may be used to measure an angular range of light that can be captured by the at least one micro lens. In other words, the plurality of optical sensing pixels can further expand an angle of the field of view and the field of view of the fingerprint detecting units by receiving light signals in multiple directions, thereby increasing an angle of the field of view and the field of view of the fingerprint detection apparatus. For example, the field of view of the fingerprint detection apparatus may be expanded from 6x9 mm² to 7.5x10.5 mm², which further improves the fingerprint identification effect.

Moreover, by disposing a plurality of optical sensing pixels below the at least one micro lens, when the number of the at least one micro lens is not equal to the number of the plurality of optical sensing pixels, a spatial period of a micro lens (that is, a space between adjacent micro lenses) is not equal to a spatial period of an optical sensing pixel (that is, a space between adjacent optical sensing pixels), thereby avoiding the occurrence of Moire fringes in a fingerprint image and improving the fingerprint identification effect. Particularly, when the number of the at least one micro lens is less than the number of the plurality of optical sensing pixels, the cost of the lens can be reduced and the density of the plurality of optical sensing pixels can be increased, thereby reducing the size and cost of the fingerprint detection apparatus.

Meanwhile, light signals in multiple directions may be multiplexed by a single fingerprint detecting unit (for example, light signals at four angles may be multiplexed by a single micro lens), and segmentation imaging may be performed on light beams at different object space aperture angles, which improves an amount of entering light of the fingerprint detection apparatus effectively, and thus reduces an exposure duration of time of the optical sensing pixels.

Moreover, since the plurality of optical sensing pixels can respectively receive oblique light signals from multiple directions, the plurality of optical sensing pixels may be divided into a plurality of optical sensing pixel groups according to the directions of the oblique light signals, the plurality of optical sensing pixel groups may be respectively used to receive the oblique light signals in multiple directions, that is, each optical sensing pixel group may generate a fingerprint image based on received oblique light signals, and thus the plurality of optical sensing pixel groups may be used to generate a plurality of fingerprint images. In this case, the plurality of fingerprint images may be superimposed to obtain a fingerprint image with a high resolution, and then fingerprint identification is performed based on the fingerprint image with the high resolution, which can improve fingerprint identification performance.

Based on the above analysis, it can be seen that oblique light signals in multiple directions returned from a finger above the display screen are respectively transmitted to the plurality of optical sensing pixels through openings provided in the at least one light shielding layer after being converged by the at least one micro lens, which can not only reduce an exposure duration of time of the plurality of optical sensing pixels and the thickness and cost of the fingerprint detection apparatus, but also improve robustness, tolerance, an angle of the field of view and the field of view of the fingerprint detection apparatus, and further improve the fingerprint identification effect, especially a fingerprint identification effect of a dry finger.

A fingerprint detecting unit of the embodiments of the present application will be described hereinafter with reference to the accompanying drawings.

In some embodiments of the present application, the number of the at least micro lens is equal to the number of the plurality of optical sensing pixels, where one micro lens is disposed above each of the plurality of optical sensing pixels.

The at least one micro lens is a rectangular array of 2×2 micro lenses, the plurality of optical sensing pixels are a rectangular array of 2×2 optical sensing pixels, and one micro lens is disposed right above each optical sensing pixel in the rectangular array of 2×2 optical sensing pixels. The at least one micro lens is a rectangular array of 2×2 micro lenses, the plurality of optical sensing pixels are a rectangular array of 2×2 optical sensing pixels, and one micro lens is disposed obliquely above each optical sensing pixel in the rectangular array of 2×2 optical sensing pixels. For example, as shown in FIG. 5, the fingerprint detecting unit 21 may include four optical sensing pixels 211 and four micro lenses 212 distributed in a rectangular array, where one micro lens 212 is disposed right above each optical sensing pixel 211. In this case, in terms of a light path design, as shown in FIG. 6, the fingerprint detecting unit 21 may include a top light shielding layer and a bottom light shielding layer. The top light shielding layer may include four openings 2141 respectively corresponding to the four micro lenses 212, and the bottom light shielding layer may include four opening 213 respectively corresponding to the four micro lenses 212.

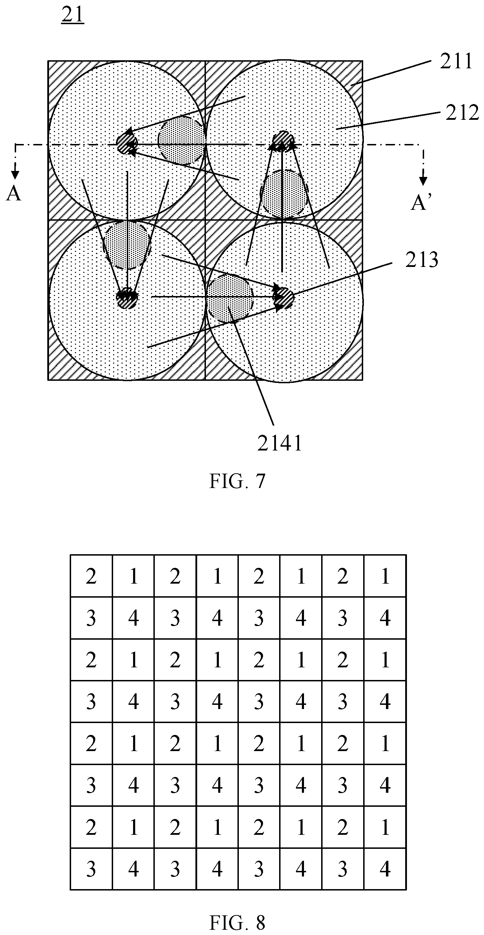

During transmission of light, the rectangular array of 2×2 micro lenses receives the oblique light signals in multiple directions in a clockwise direction, and each micro lens in the rectangular array of 2×2 micro lenses converges the received oblique light signals to an optical sensing pixel under an adjacent micro lens in the clockwise direction; or the rectangular array of 2×2 micro lenses receives the oblique light signals in multiple directions in a counterclockwise direction, and each micro lens in the rectangular array of 2×2 micro lenses converges the received oblique light signals to an optical sensing pixel under an adjacent micro lens in the counterclockwise direction. With reference to FIG. 7, the four micro lenses 212 converge oblique light signals in multiple directions respectively to the four optical sensing pixels 211 along the following paths: the micro lens 212 at the upper right corner converges the received oblique light signals to the optical sensing pixel 211 at the upper left corner, the micro lens 212 at the upper left corner converges the received oblique light signals to the optical sensing pixel 211 at the lower left corner, the micro lens 212 at the lower left corner converges the received oblique light signals to the optical sensing pixel 211 at the lower right corner, and the micro lens 212 at the lower right corner converges the received oblique light signals to the optical sensing pixel 211 at the upper right corner. Accordingly, when the fingerprint detection apparatus includes a plurality of fingerprint detecting units distributed in an array, a plurality of fingerprint images may be generated based on received light signals in multiple directions, and then a fingerprint image with a high resolution is obtained to improve the fingerprint identification effect.

In other words, a rectangular array of 4×4 fingerprint detecting units may include optical sensing pixel arrays as shown in FIG. 8, where "1" represents an optical sensing pixel for receiving an oblique light signal in a first direction, "2" represents an optical sensing pixel for receiving an oblique light signal in a second direction, "3 represents an optical sensing pixel for receiving an oblique light signal in a third direction, and "4" represents an optical sensing pixel for receiving an oblique light signal in a fourth direction. That is, the optical sensing pixels represented by "1", "2", "3" and "4" each may be used to generate a fingerprint image, that is, a total of four fingerprint images may be generated, and these four fingerprint images may be used to merge into a fingerprint image with a high resolution, thereby improving the identification effect of the fingerprint detection apparatus. With reference to FIG. 7, the first to fourth directions may be directions of the oblique light signals received by the micro lens 212 at the lower right corner, the micro lens 212 at the upper right corner, the micro lens 212 at the upper left corner and the micro lens 212 at the lower left corner.

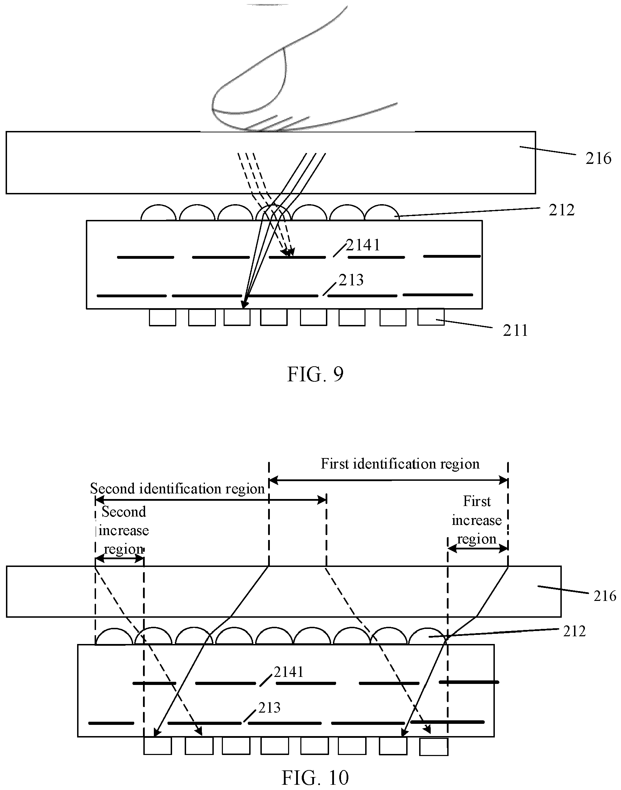

FIG. 9 is a side view of a fingerprint detection apparatus located below a display screen.

As shown in FIG. 9, the fingerprint detection apparatus may include micro lenses 212 distributed in an array, a top light shielding layer and a bottom light shielding layer located below the micro lenses 212, and optical sensing pixels distributed in an array located below the bottom light shielding layer, where for each micro lens 212, the top light shielding layer and the bottom light shielding layer are respectively provided with a corresponding opening 2141 and opening 213. The fingerprint identification apparatus is disposed below a display screen 216. Each micro lens 212 converges received oblique light signals in specific directions (light signals shown by solid lines in the drawing) to a corresponding optical sensing pixel via a corresponding opening 2141 and opening 213, and transmits received oblique light signals in non-specific directions (light signals shown by dashed lines in the drawing) to regions of the light shielding layers other than the openings 2141 and the openings 214 to avoid the received oblique light signals in non-specific directions from being received by other optical sensing pixels, thereby implementing segmentation imaging of a fingerprint image.

FIG. 10 is a schematic diagram of light paths for oblique light signals in two directions according to an embodiment of the present application.

With reference to FIG. 7, FIG. 10 may be a schematic side cross-sectional view of a fingerprint detection apparatus including the fingerprint detecting unit shown in FIG. 7 in an A-A' direction. In this case, one micro lens 212 in the fingerprint detecting unit (for example, the micro lens 212 at the upper right corner shown in FIG. 7) converges a received oblique light signal (a light signal shown by a solid line in FIG. 10) in one direction (that is, the second direction) to a corresponding optical sensing pixel (for example, the optical sensing pixel 211 at the upper left corner shown in FIG. 7) via a corresponding opening 2141 and opening 213, and another micro lens 212 in the fingerprint detecting unit (for example, the micro lens 212 at the lower left corner shown in FIG. 7) converges a received oblique light signal (a light signal shown by a dashed line in FIG. 10) in another direction (that is, the fourth direction) to a corresponding optical sensing pixel (for example, the optical sensing pixel 211 at the lower right corner shown in FIG. 7) via a corresponding opening 2141 and opening 213.

During capturing of a fingerprint, a fingerprint identification region (also referred to as a fingerprint capturing region or a fingerprint detecting region) of the fingerprint detection apparatus shown in FIG. 10 includes a first identification region and a second identification region, where a fingerprint identification region corresponding to the micro lens 212 for converging the oblique light signal in the second direction is the first identification region, and a fingerprint identification region corresponding to the micro lens for converging the oblique light signal in the fourth direction is the second identification region. The first identification region is offset to right by a first increase region relative to an array formed by the optical sensing pixels, and the second identification region is offset to left by a second increase region relative to the array formed by the optical sensing pixels. In other words, assuming that the first identification region and the second identification region each are equal to a region where the optical sensing pixels array is located, relative to a fingerprint detection apparatus that only receives a light signal in one direction, the identification region of the fingerprint detection apparatus shown in FIG. 10 additionally include the first increase region and the second increase region, which effectively increases a visible region (that is, the field of view). In addition, an overlapping region between the first identification region and the second identification region could effectively improve an image resolution of a fingerprint image, and further improve the fingerprint identification effect.

It should be understood that the light path design shown in FIG. 7 is only an example of the present application and should not be understood as limitation to the present application

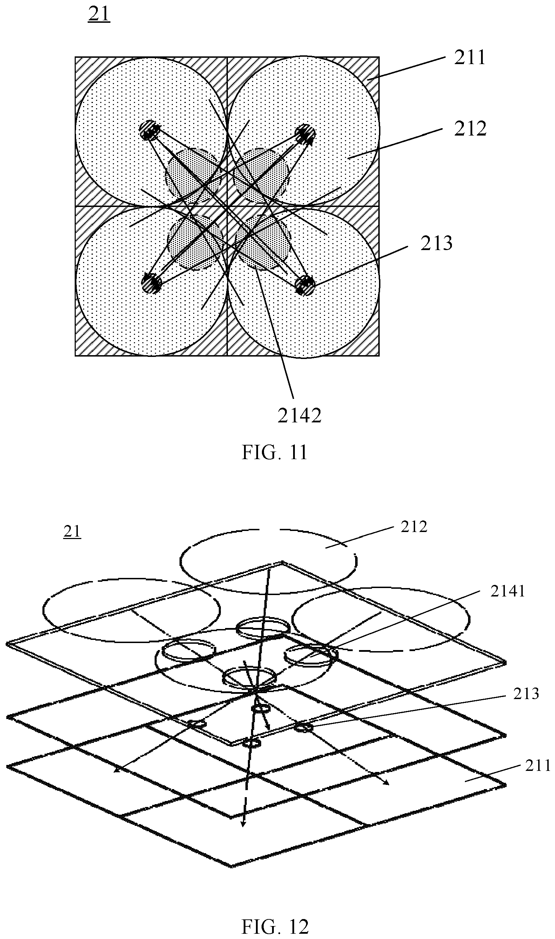

For a light path design, in another implementation manner, the rectangular array of 2×2 micro lenses receives the oblique light signals in multiple directions in a diagonal direction of the rectangular array of 2×2 micro lenses, and each micro lens in the rectangular array of 2×2 micro lenses converges the received oblique light signals to an optical sensing pixel under an adjacent micro lens in the diagonal direction. For example, as shown in FIG. 11 and FIG. 12, the four micro lenses 212 may converge oblique light signals in multiple directions respectively to the four optical sensing pixels 211 along the following paths: the micro lens 212 at the upper right corner converges the received oblique light signals to the optical sensing pixel 211 at the lower left corner, the micro lens 212 at the lower left corner converges the received oblique light signals to the optical sensing pixel 211 at the upper right corner, the micro lens 212 at the upper left corner converges the received oblique light signals to the optical sensing pixel 211 at the lower right corner, and the micro lens 212 at the lower right corner converges the received oblique light signals to the optical sensing pixel 211 at the upper left corner. Accordingly, when the fingerprint detection apparatus includes a plurality of fingerprint detecting units distributed in an array, a plurality of fingerprint images may be generated based on received light signals in multiple directions, and then a fingerprint image with a high resolution is obtained to improve the fingerprint identification effect.

Similarly, a rectangular array of 4×4 fingerprint detecting units may include optical sensing pixel arrays as shown in FIG. 8, where "1" represents an optical sensing pixel for receiving an oblique light signal in a first direction, "2" represents an optical sensing pixel for receiving an oblique light signal in a second direction, "3 represents an optical sensing pixel for receiving an oblique light signal in a third direction, and "4" represents an optical sensing pixel for receiving an oblique light signal in a fourth direction. That is, the optical sensing pixels represented by "1", "2", "3" and "4" each may be used to generate a fingerprint image, that is, a total of four fingerprint images may be generated, and these four fingerprint images may be used to merge into a fingerprint image with a high resolution, thereby improving the identification effect of the fingerprint detection apparatus. With reference to FIG. 11, the first to fourth directions may be directions of the oblique light signals received by the micro lens 212 at the lower left corner, the micro lens 212 at the lower right corner, the micro lens 212 at the upper right corner and the micro lens 212 at the upper left corner.

The fingerprint detection apparatus includes at least one light shielding layer and an optical sensing pixel array. The at least one light shielding layer is a plurality of light shielding layers. One opening in an array of small holes of each of the plurality of light shielding layers corresponds to a plurality of optical sensing pixels in the optical sensing pixel array, or one opening in an array of small holes of each of the plurality of light shielding layers corresponds to one optical sensing pixel in the optical sensing pixel array. For example, one opening in an array of small holes of a top light shielding layer of the plurality of light shielding layers corresponds to a plurality of optical sensing pixels in the optical sensing pixel array. For another example, one opening in an array of small holes of a top light shielding layer of the plurality of light shielding layers corresponds to one optical sensing pixel in the optical sensing pixel array. One opening in an array of small holes of a bottom light shielding layer of the plurality of light shielding layers corresponds to one optical sensing pixel in the optical sensing pixel array. Optionally, apertures of openings in the plurality of light shielding layers corresponding to a same optical sensing pixel decrease in order from top to bottom. In another implementation, the Z light shielding layers are one light shielding layer. Optionally, a thickness of the one light shielding layer is greater than a preset threshold. A metal wiring layer of the optical sensing pixel array is disposed at a position of a back focal plane of the micro lens array, and the metal wiring layer is provided with one opening formed above each optical sensing pixel in the optical sensing pixel array to form the bottom light shielding layer.

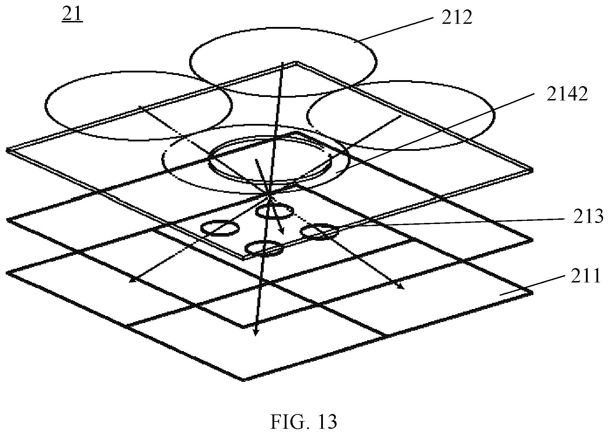

In other words, the fingerprint detecting unit may include at least one light shielding layer and a plurality of optical sensing pixels, where each of the at least one light shielding layer is provided with openings corresponding to the plurality of optical sensing pixels. For example, the at least one light shielding layer may be a plurality of light shielding layers, and a top light shielding layer of the plurality of light shielding layers may be provided with at least one opening corresponding to the plurality of optical sensing pixels. For example, one small hole in an array of small holes of the top light shielding layer corresponds to at least two of the plurality of optical sensing pixels. For example, as shown in FIG. 12, the at least one light shielding layer may include a top light shielding layer and a bottom light shielding layer, where the top light shielding layer is provided with four openings 2141 respectively corresponding to four optical sensing pixels. The bottom light shielding layer is provided with four openings 213 respectively corresponding to the four optical sensing pixels. For another example, as shown in FIG. 13, the at least one light shielding layer may include a top light shielding layer and a bottom light shielding layer, where the top light shielding layer is provided with one opening 2142 corresponding to four optical sensing pixels. The bottom light shielding layer is provided with four openings 213 respectively corresponding to the four optical sensing pixels.

It should be noted that the openings provided in the light shielding layers in FIG. 12 and FIG. 13 are described only by an example of the fingerprint detecting unit shown in FIG. 11, and the implementation manners thereof are applicable to various embodiments of the present application, which is not limited in the present application. For example, the at least one light shielding layer may be light shielding layers more than 2 layers. Alternatively, the at least one light shielding layer may be one light shielding layer, that is, the at least one light shielding layer may be a straight hole collimator or an oblique hole collimator with a certain thickness. It should also be understood that FIG. 5 to FIG. 13 are only examples that one micro lens is disposed above each optical sensing pixel and should not be understood as limitation to the present application. For example, the fingerprint detecting unit may further include other numbers or other arrangements of micro lenses or optical sensing pixels. For example, in another implementation manner, the at least one micro lens is multiple rows of micro lenses, and the plurality of optical sensing pixels are multiple rows of optical sensing pixels corresponding to the multiple rows of micro lenses, where each row of optical sensing pixels in the multiple rows of optical sensing pixels are disposed below a corresponding row of micro lenses in a dislocated manner. Optionally, the multiple rows of micro lenses may be multiple columns or lines of micro lenses. The multiple rows of optical sensing pixels may be multiple columns or lines of optical sensing pixels.

The at least one light shielding layer may be provided with a corresponding light path design such that the multiple rows of micro lenses receives the oblique light signals in multiple directions in a dislocation direction of the multiple rows of optical sensing pixels, and each row of micro lenses in the multiple rows of micro lenses converge the received oblique light signals to optical sensing pixels under the same row of micro lenses or adjacent micro lenses.

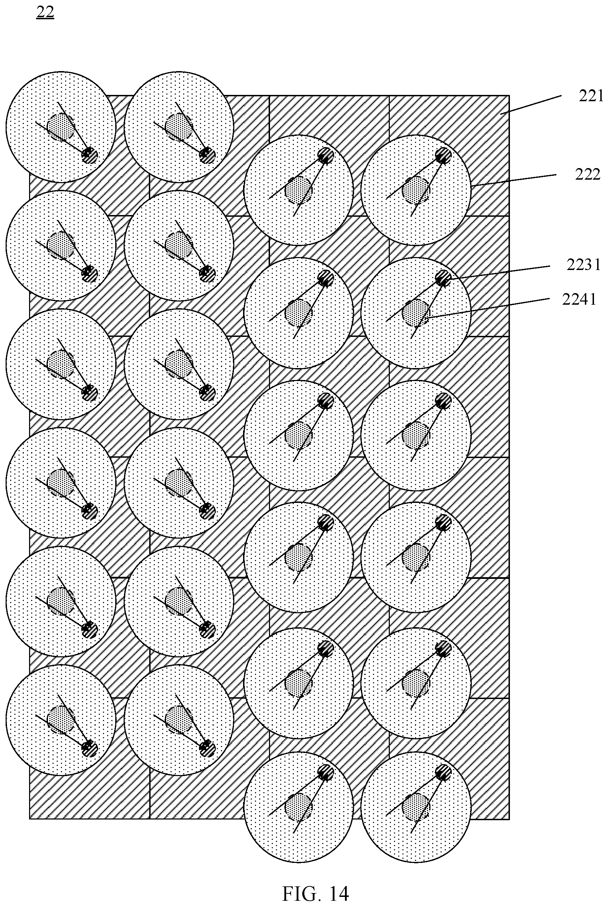

For example, as shown in FIG. 14, the fingerprint detecting unit 22 may include four columns of optical sensing pixels distributed in a rectangular array and four columns of micro lenses corresponding to the four columns of optical sensing pixels, where each column of optical sensing pixels in the four columns of optical sensing pixels include six optical sensing pixels 211, each column of micro lenses in the four columns of micro lenses include six micro lenses 222, and one optical sensing pixel 221 is disposed under one micro lens 222 in a dislocated manner. The fingerprint detecting unit 22 may further include a top light shielding layer and a bottom light shielding layer. In this case, for each micro lens 222, the top light shielding layer and the bottom light shielding layer may be provided with a corresponding opening 2241 and opening 2231, respectively. Each micro lens 222 in each row of micro lenses in the multiple rows of micro lenses may converge received light signals to an optical sensing pixel 221 obliquely below the same micro lens 222 via a corresponding opening 2241 and opening 2231. Accordingly, when the fingerprint detection apparatus includes a plurality of fingerprint detecting units distributed in an array, a plurality of fingerprint images may be generated based on received light signals in multiple directions, and then a fingerprint image with a high resolution is obtained to improve the fingerprint identification effect.

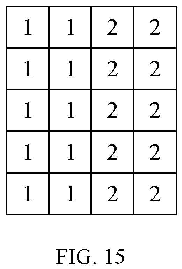

In other words, the fingerprint detecting unit shown in FIG. 14 may include an optical sensing pixel array as shown in FIG. 15, where "1" represents an optical sensing pixel for receiving an oblique light signal in a first direction, and "2" represents an optical sensing pixel for receiving an oblique light signal in a second direction. That is, the optical sensing pixels represented by "1" and "2" each may be used to generate a fingerprint image, that is, a total of two fingerprint images may be generated, and these two fingerprint images may be used to merge into a fingerprint image with a high resolution, thereby improving the identification effect of the fingerprint detection apparatus. With reference to FIG. 14, based on an order from left to right, the first direction may be a direction of the oblique light signals received by the micro lenses in the first and second columns of micro lenses, and the second direction may be a direction of the oblique light signals received by the micro lenses in the third and fourth columns of micro lenses.

In one embodiment of the present application, a projection of each micro lens in each row of micro lenses in the multiple rows of micro lenses on a plane where the display screen is located is a circle, and a projection of each optical sensing pixel in each row of optical sensing pixels in the multiple rows of optical sensing pixels on the plane where the display screen is located is a rectangle. A projection of a center of each optical sensing pixel in each row of optical sensing pixels in the multiple rows of optical sensing pixels on the plane where the display screen is located, relative to a projection of a center of a corresponding micro lens on the plane where the display screen is located, is offset by a preset distance in a dislocation direction of the multiple rows of optical sensing pixels, and the present distance is less than or equal to a side length of the rectangle, or the preset distance is less than or equal to a diameter of the circle. In one implementation manner, as shown in FIG. 14, the dislocation direction is a diagonal direction of each optical sensing pixel in each row of optical sensing pixels in the multiple rows of optical sensing pixels, that is, each optical sensing pixel 221 in each row of optical sensing pixels in the multiple rows of optical sensing pixels is offset by a preset distance in a diagonal direction of the same optical sensing pixel 221. In this case, a corresponding opening 2241 and opening 2231 are disposed above each optical sensing pixel 221 in each row of optical sensing pixels in the multiple rows of optical sensing pixels, that is, at least one light shielding layer in the fingerprint detecting unit 22 is provided with a corresponding opening above each optical sensing pixel 221. The dislocation direction is a direction where a vertical side of each optical sensing pixel in each row of optical sensing pixels in the multiple rows of optical sensing pixels is located. The vertical side may be a direction parallel to an arrangement direction of the optical sensing pixels.

It should be noted that the preset distance may also be an offset distance in a direction where a side of the optical sensing pixel 221 is located, for example, two sides of the optical sensing pixel 221 are an X-axis direction and a Y-axis direction, where the preset distance may include an offset distance in the X-axis direction and an offset distance in the Y-axis direction. For example, assuming that a side length of the optical sensing pixel is 12.5 mm and a diameter of the micro lens is 11.5 mm, the offset distance in the X-axis direction may be 4-5 mm and the offset distance in the Y-axis direction may be 4-5 mm. Certainly, the foregoing parameters are merely examples and should not be understood as limitation to themselves. For example, the offset distance in the X-axis direction may be not equal to the offset distance in the Y-axis direction. For another example, the offset distance in the X-axis direction or the offset distance in the Y-axis direction may be greater than 5 mm or less than 4 mm.

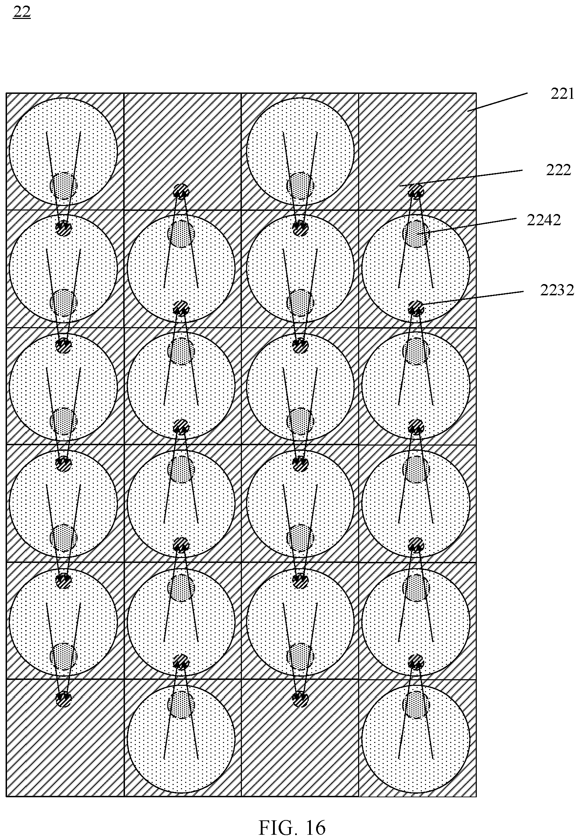

Regarding the dislocation direction, in another implementation manner, as shown in FIG. 16, the fingerprint detecting unit 22 may include a top light shielding layer and a bottom light shielding layer. In this case, for each micro lens 222, the top light shielding layer and the bottom light shielding layer may be provided with a corresponding opening 2242 and opening 2232, respectively. Each micro lens 222 in each row of micro lenses in the multiple rows of micro lenses may converge received oblique light signals to an optical sensing pixel 221 right below an adjacent micro lens 222 via a corresponding opening 2242 and opening 2232. For example, the micro lens 222 at the upper left corner may converge the received oblique light signals to an optical sensing pixel 221 right below an adjacent micro lens 222 in the first column and second line. In this case, the bottom light shielding layer may be provided with a corresponding opening 2232 above each optical sensing pixel 221 in each row of optical sensing pixels in the multiple rows of optical sensing pixels, and the top light shielding layer may be provided with a corresponding opening 2242 above an optical sensing pixel 221 adjacent to the same optical sensing pixel 221.

It should be understood that the dislocation direction may also be other directions. For example, the dislocation direction is a direction where a horizontal side of each optical sensing pixel in each row of optical sensing pixels in the multiple rows of optical sensing pixels is located. The horizontal side may be a direction perpendicular to an arrangement direction of the optical sensing pixels.

In other embodiments of the present application, the number of the at least micro lens is less than the number of the plurality of optical sensing pixels.

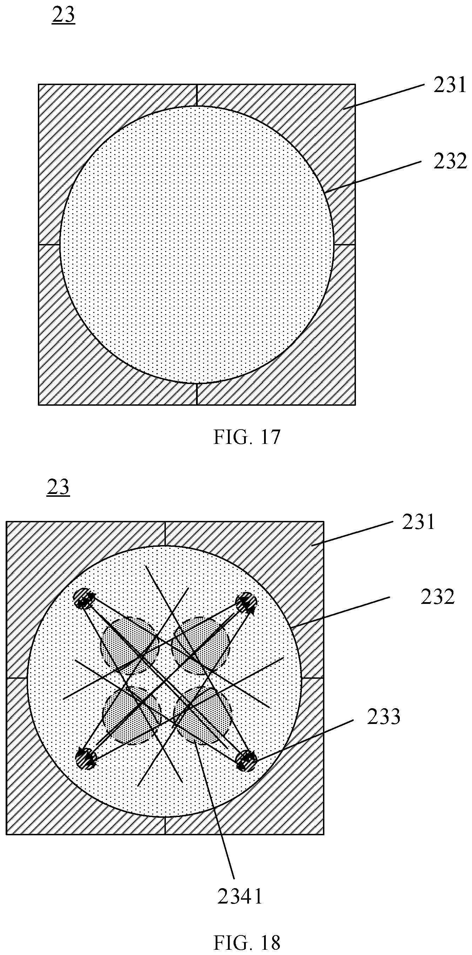

In one implementation manner, the at least one micro lens is one micro lens, and the plurality of optical sensing pixels are a rectangular array of 2×2 optical sensing pixels, where the one micro lens is disposed right above the rectangular array of 2×2 optical sensing pixels. For example, as shown in FIG. 17, the fingerprint detecting unit 23 may include one micro lens 232 and four optical sensing pixels 231 distributed in a rectangular array.

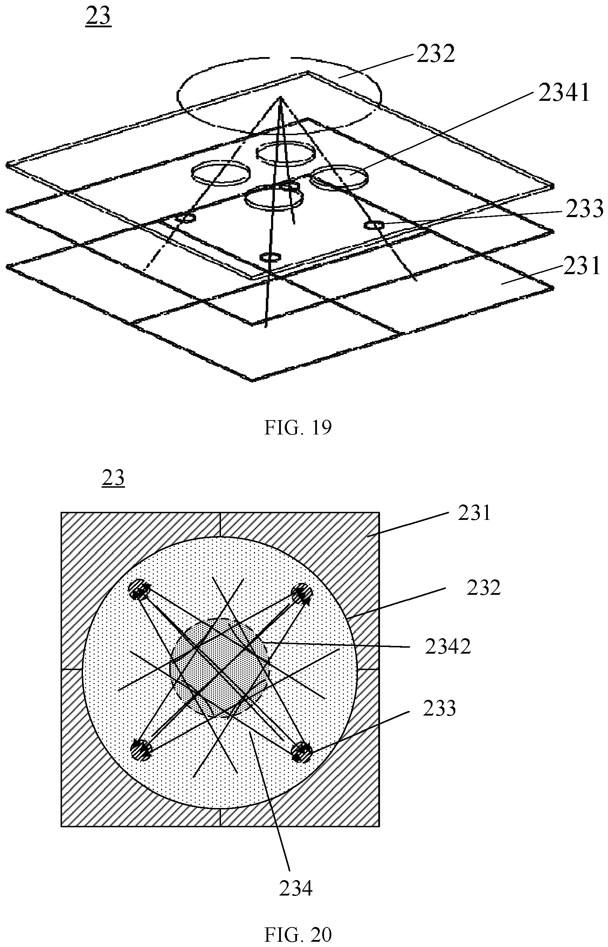

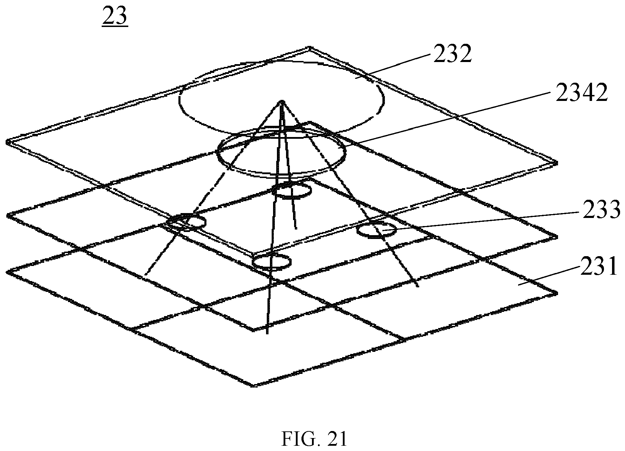

In a specific light path design, at least one light shielding layer in the fingerprint detecting unit 23 may be respectively provided with openings corresponding to the four optical sensing pixels 231 under the one micro lens such that the one micro lens may receive the oblique light signals in multiple directions in a diagonal direction of the rectangular array of 2×2 optical sensing pixels, and the one micro lens may converge the oblique light signals in multiple directions respectively to optical sensing pixels in the rectangular array of optical sensing pixels in the diagonal direction to increase an amount of signals that can be received by each optical sensing pixel, thereby improving the fingerprint identification effect. For example, as shown in FIG. 18 or FIG. 19, the at least one light shielding layer may include a top light shielding layer and a bottom light shielding layer. The top light shielding layer is provided with openings 2341 respectively corresponding to the four optical sensing pixels 231 under the one micro lens 232, and the bottom light shielding layer is provided with openings 233 respectively corresponding to the four optical sensing pixels 231 under the one micro lens 232. The one micro lens 232 converges the received light signals in multiple directions respectively to the four optical sensing pixels 231 via the corresponding openings 2341 and openings 233. Certainly, four small holes of the top light shielding layer corresponding to the four optical sensing pixels 231 may also merge into one large hole, such as an opening 2342 shown in FIG. 20 or FIG. 21.

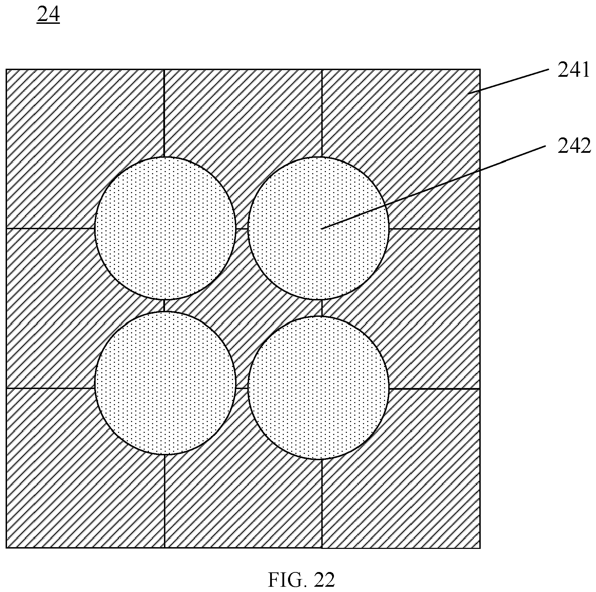

In another implementation manner, the at least one micro lens is a rectangular array of 2×2 micro lenses, the plurality of optical sensing pixels are a rectangular array of 3×3 optical sensing pixels, and one micro lens is disposed right above every four adjacent optical sensing pixels in the 3×3 rectangular array. For example, one micro lens is disposed right above a center position of every four adjacent optical sensing pixels in the 3×3 rectangular array. For example, as shown in FIG. 22, the fingerprint detecting unit 24 may include four micro lenses 242 distributed in a rectangular array and nine optical sensing pixels 241 distributed in a rectangular array.

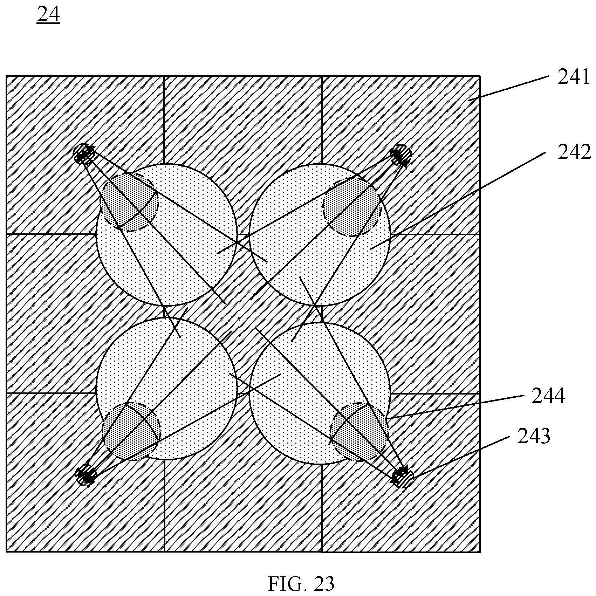

In a specific light path design, as shown in FIG. 23, at least one light shielding layer in the fingerprint detecting unit 24 may be respectively provided with openings corresponding to optical sensing pixels 241 at the four corners of the rectangular array of 3×3 optical sensing pixels such that each micro lens 242 in the rectangular array of 2×2 micro lenses may converge received oblique light signals to an optical sensing pixel 241 in the optical sensing pixels 241 at the four corners of the rectangular array of 3×3 optical sensing pixels that is closest to the same micro lens 242. For example, the at least one light shielding layer may include a top light shielding layer and a bottom light shielding layer. The top light shielding layer is provided with openings 244 respectively corresponding to the optical sensing pixels 241 at the four corners, and the bottom light shielding layer is provided with openings 243 respectively corresponding to the optical sensing pixels 241 at the four corners. Accordingly, the four micro lenses 242 may converge the oblique light signals in multiple directions respectively to the optical sensing pixels 241 at the four corners via the corresponding openings 244 and openings 243.

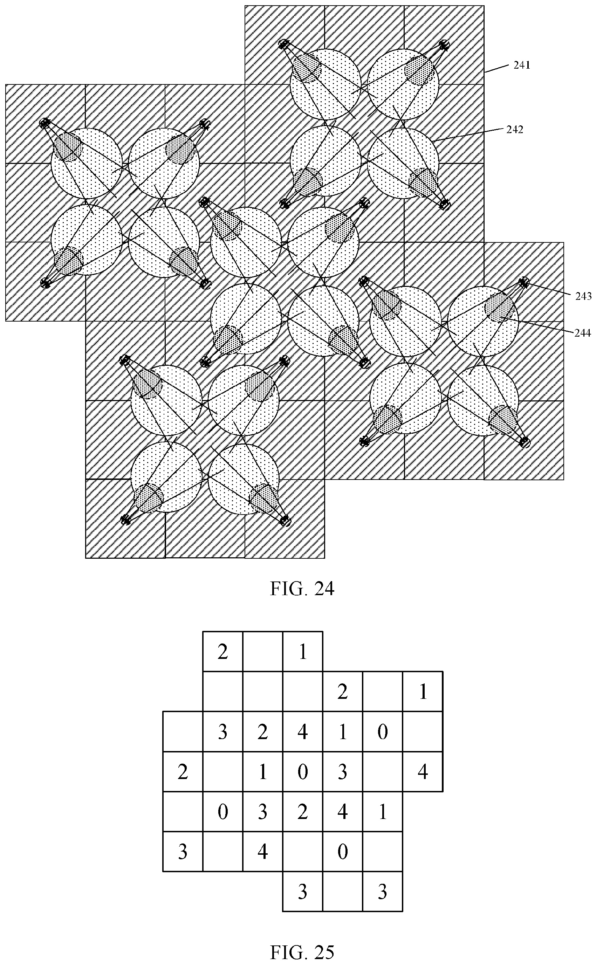

Since only optical sensing pixels 241 at the four corners in the rectangular array of 3×3 optical sensing pixels will receive oblique light signals for detecting fingerprint information, in order to increase utilization of the optical sensing pixels, in some embodiments of the present application, a fingerprint detection apparatus including a plurality of fingerprint detecting units 24 may be formed by means of a staggered arrangement. For example, as shown in FIG. 24, for a central fingerprint detecting unit located at a middle position, an optical sensing pixel 241 between an optical sensing pixel 241 at the upper left corner and an optical sensing pixel 241 at the upper right corner may be multiplexed as an optical sensing pixel 241 located at the lower left corner of another fingerprint detecting unit, an optical sensing pixel 241 between the optical sensing pixel 241 at the upper left corner and an optical sensing pixel 241 at the lower left corner of the central fingerprint detecting unit may be multiplexed as an optical sensing pixel 241 located at the lower right corner of another fingerprint detecting unit, an optical sensing pixel 241 between the optical sensing pixel 241 at the lower left corner and an optical sensing pixel 241 at the lower right corner of the central fingerprint detecting unit may be multiplexed as an optical sensing pixel 241 located at the upper right corner of another fingerprint detecting unit, and an optical sensing pixel 241 between the optical sensing pixel 241 at the lower right corner and the optical sensing pixel 241 at the upper right corner of the central fingerprint detecting unit may be multiplexed as an optical sensing pixel 241 located at the upper left corner of another fingerprint detecting unit.

In other words, the fingerprint detection apparatus may include a plurality of optical sensing pixels as shown in FIG. 25, where "0" represents an optical sensing pixel not for receiving a light signal, and "1", "2", "3" and "4" respectively represent optical sensing pixels for receiving light signals in four different directions. That is, the optical sensing pixels represented by "1", "2", "3" and "4" each may be used to generate a fingerprint image, that is, a total of four fingerprint images may be generated, and these four fingerprint images may be used to merge into a fingerprint image with a high resolution, thereby improving the identification effect of the fingerprint detection apparatus.

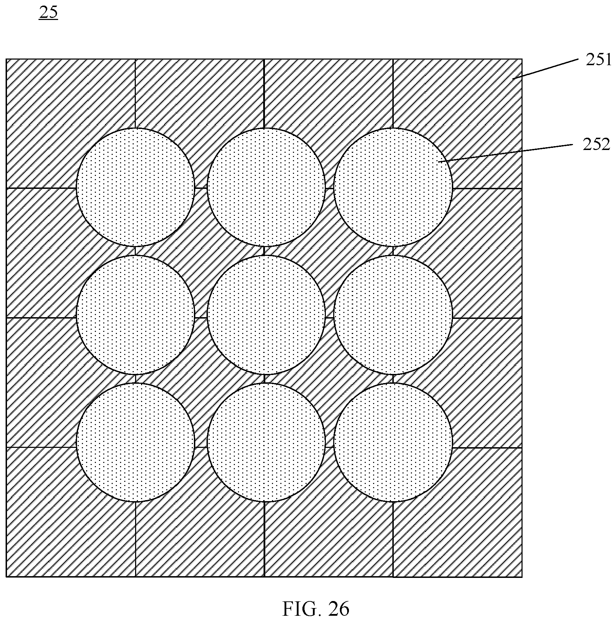

In another implementation manner, the at least one micro lens is a rectangular array of 3×3 micro lenses, the plurality of optical sensing pixels are a rectangular array of 4×4 optical sensing pixels, and one micro lens is disposed right above every four adjacent optical sensing pixels in the rectangular array of 4×4 optical sensing pixels. For example, as shown in FIG. 26, the fingerprint detecting unit 25 may include nine micro lenses 252 distributed in a rectangular array and 16 optical sensing pixels 251 distributed in a rectangular array. One micro lens 252 is disposed right above every four adjacent optical sensing pixels 251 in the 16 optical sensing pixels 251.

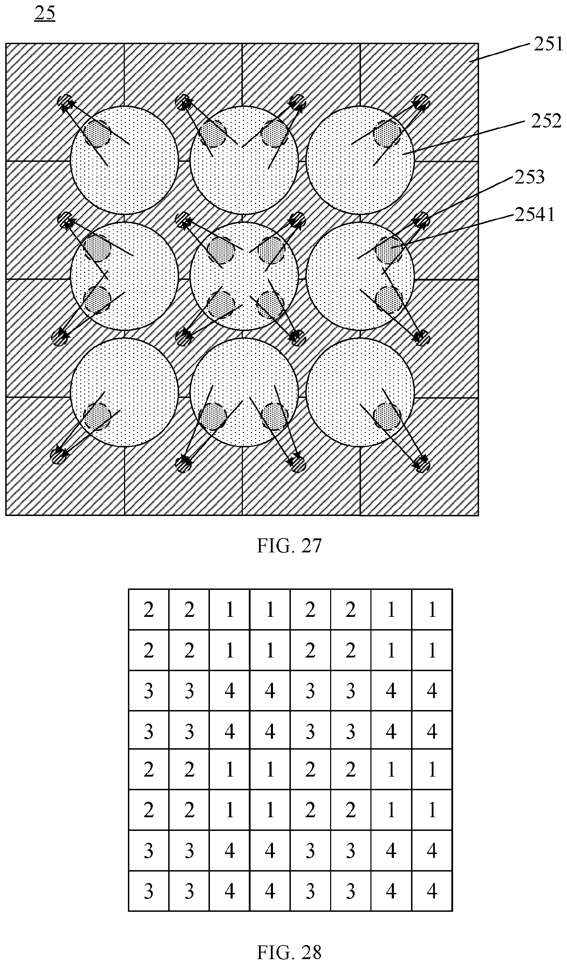

In a specific light path design, at least one light shielding layer in the fingerprint detecting unit 25 may be respectively provided with openings corresponding to the 16 optical sensing pixels 251 such that a central micro lens in the rectangular array of 3×3 micro lenses converges received oblique light signals respectively to four optical sensing pixels under the central micro lens, each of the micro lenses at the four corners in the rectangular array of 3×3 micro lenses converges received oblique light signals to an optical sensing pixel located at a corner of the rectangular array of 4×4 optical sensing pixels under the same micro lens, and each of the other micro lenses in the rectangular array of 3×3 micro lenses converges received oblique light signals to two optical sensing pixels on the outside under the same micro lens. For example, as shown in FIG. 27, the at least one light shielding layer may include a top light shielding layer and a bottom light shielding layer. The top light shielding layer is provided with openings 2541 respectively corresponding to the 16 optical sensing pixels 251, and the bottom light shielding layer is provided with openings 253 respectively corresponding to the 16 optical sensing pixels 251. Accordingly, the nine micro lenses 252 may converge the oblique light signals in multiple directions respectively to the 16 optical sensing pixels 251 via the corresponding openings 2541 and openings 253.

In other words, the fingerprint detection apparatus may include a plurality of optical sensing pixels as shown in FIG. 28, where "1", "2", "3" and "4" respectively represent optical sensing pixels for receiving light signals in four different directions. That is, the optical sensing pixels represented by "1", "2", "3" and "4" each may be used to generate a fingerprint image, that is, a total of four fingerprint images may be generated, and these four fingerprint images may be used to merge into a fingerprint image with a high resolution, thereby improving the identification effect of the fingerprint detection apparatus.

Certainly, FIG. 27 is only an example of the present application and should not be understood as limitation to the present application

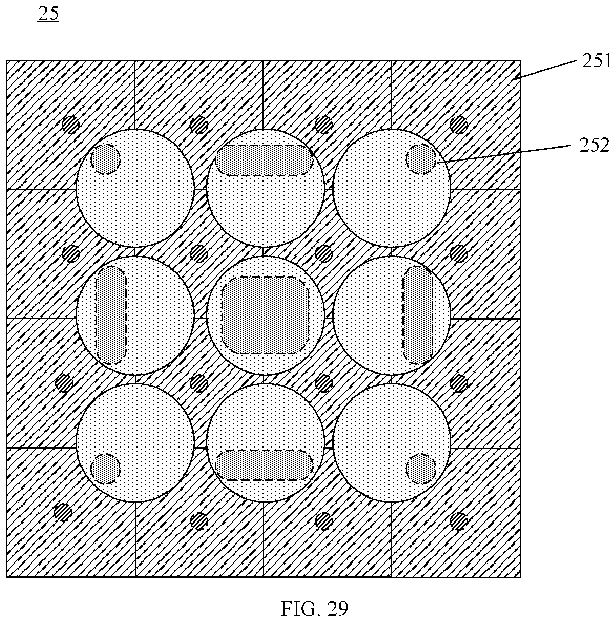

For example, as shown in FIG. 29, two small holes in the top light shielding layer corresponding to two optical sensing pixels 251 located between two corners in the rectangular array of 4×4 optical sensing pixels may merge into a large hole, and four small holes in the top light shielding layer corresponding to four adjacent optical sensing pixels 251 located at a center position of the rectangular array of 4×4 optical sensing pixels may merge into a large hole, so as to reduce processing difficulty and increase an amount of converged light signals, thereby improving the fingerprint identification effect of the fingerprint detection apparatus.

Fingerprint detecting unit that can be arranged in a dislocated manner in arrangement have been described above, and fingerprint detecting units that are arranged in a staggered manner in a light path structure will be described below.

For example, a fingerprint detection apparatus may include a plurality of fingerprint detecting units distributed in an array or arranged in a staggered manner, each of the plurality of fingerprint detecting units may include one micro lens, at least one light shielding layer and a plurality of optical sensing pixels, each of the at least one light shielding layer is provided with openings corresponding to the plurality of optical sensing pixels, and the at least one light shielding layer is disposed between the at least one micro lens and the plurality of optical sensing pixels. Micro lenses in the plurality of fingerprint detecting units may converge received oblique light signals to optical sensing pixels in a plurality of adjacent fingerprint detecting units. In other words, a plurality of optical sensing pixels in each fingerprint detecting unit of the fingerprint detection apparatus are used to receive oblique light signals converged by micro lenses in a plurality of adjacent fingerprint detecting units. For convenience of description, a plurality of fingerprint detecting units arranged in a staggered manner are described below from the perspective of a fingerprint detection apparatus.

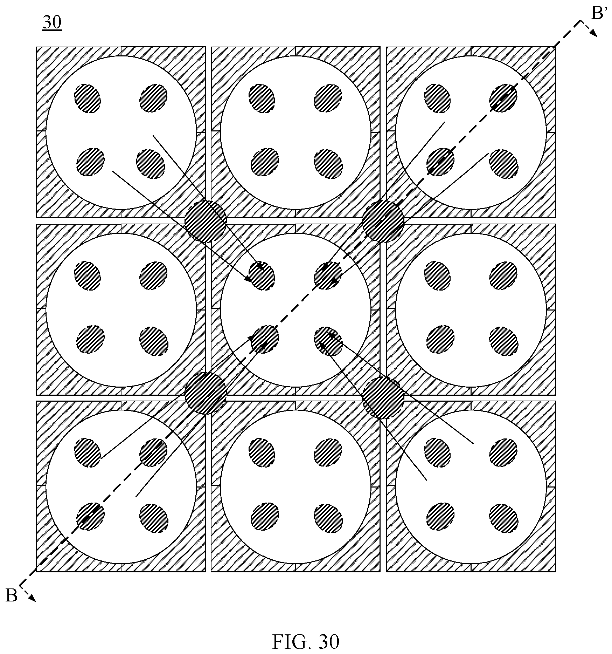

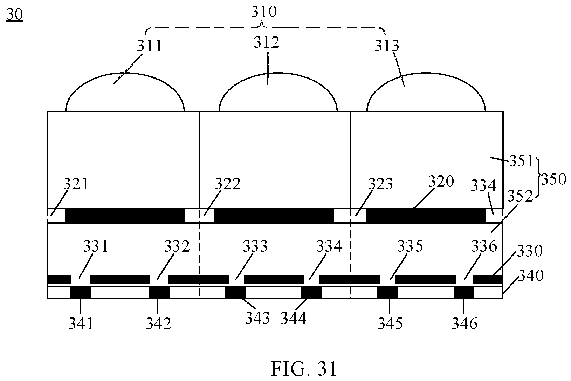

FIG. 30 is a schematic top view of a fingerprint detection apparatus 30 according to an embodiment of the present application, and FIG. 31 is a side cross-sectional view of the fingerprint detection apparatus 30 shown in FIG. 30 in a B-B' direction.

As shown in FIG. 30, the fingerprint detection apparatus 30 includes 3×3 fingerprint detecting units, where each of the 3×3 fingerprint detecting units includes one micro lens and a rectangular array of 2×2 optical sensing pixels located below the one micro lens. In an example of a central fingerprint detecting unit located at a middle position of the 3×3 fingerprint detecting units, optical sensing pixels in a rectangular array of 2×2 optical sensing pixels in the central fingerprint detecting unit are respectively used to receive oblique light signals converged by micro lenses in fingerprint detecting units located at the four corners of the 3×3 fingerprint detecting units. In other words, a micro lens in a central fingerprint detecting unit located at a middle position of the rectangular array of 3×3 fingerprint detecting units is used to converge received oblique light signals in multiple directions to optical sensing pixels in an adjacent fingerprint detecting unit that is close to the central fingerprint detecting unit in a diagonal direction of the rectangular array of 3×3 fingerprint detecting units. Certainly, alternatively, each micro lens in the fingerprint detection apparatus 30 may also be used to converge received oblique light signals in multiple directions to optical sensing pixels disposed below an adjacent micro lens in a side direction of a rectangular array of 3×3 fingerprint detecting units centered on the same micro lens.

As shown in FIG. 31, the fingerprint detection apparatus 30 may include a micro lens array 310, at least one light shielding layer and an optical sensing pixel array 340. The micro lens array 310 may be disposed below a display screen of an electronic device, the at least one light shielding layer may be disposed below the micro lens array 310, and the optical sensing pixel array 340 may be disposed below the at least one light shielding layer. The micro lens array 310 and the at least one light shielding layer may be a light directing structure included in the optical component 132 shown in FIG. 3 or FIG. 4, and the optical sensing pixel array 340 may be the sensing array 133 having the plurality of optical sensing units 131 (which may also be referred to as optical sensing pixels, photosensitive pixels, pixel units, or the like) shown in FIG. 1 to FIG. 4, which will not be described redundantly herein to avoid repetition.

The micro lens array 310 includes a plurality of micro lenses. For example, the micro lens array 310 may include a first micro lens 311, a second micro lens 312 and a third micro lens 313. The at least one light shielding layer may include a plurality of light shielding layers. For example, the at least one light shielding layer may include a first light shielding layer 320 and a second light shielding layer 330. The optical sensing pixel array 340 may include a plurality of optical sensing pixels. For example, the optical sensing pixel array may include a first optical sensing pixel 341, a second optical sensing pixel 342, a third optical sensing pixel 343, a fourth optical sensing pixel 344, a fifth optical sensing pixel 345 and a sixth optical sensing pixel 346. The first light shielding layer 320 and the second light shielding layer 330 are respectively provided with at least one opening corresponding to each of the plurality of micro lenses (that is, the first micro lens 311, the second micro lens 312 and the third micro lens 313). For example, the first light shielding layer 320 is provided with a first opening 321 and a second opening 322 corresponding to the first micro lens 311, the first light shielding layer 320 is further provided with the second opening 322 and a third opening 323 corresponding to the second micro lens 312, and the first light shielding layer 320 is provided with the third opening 323 and a fourth opening 324 corresponding to the third micro lens 313. Similarly, the second light shielding layer 330 is provided with a fifth opening 331 and a sixth opening 332 corresponding to the first micro lens 311, the second light shielding layer 330 is further provided with a seventh opening 333 and a eighth opening 334 corresponding to the second micro lens 312, and the second light shielding layer 330 is provided with a ninth opening 335 and a tenth opening 336 corresponding to the third micro lens 313.

In a specific light path design, a plurality of optical sensing pixels are disposed under each micro lens in the micro lens array 310. The plurality of optical sensing pixels disposed under the each micro lens are respectively used to receive light signals converged by a plurality of adjacent micro lenses. In an example of the second micro lens 312, the third optical sensing pixel 343 and the fourth optical sensing pixel 344 may be disposed under the second micro lens 312, where the third optical sensing pixel 343 may be used to receive an oblique light signal converged by the first micro lens 311 and passing through the second opening 322 and the seventh opening 333, and the fourth optical sensing pixel 344 may be used to receive an oblique light signal converged by the third micro lens 313 and passing through the third opening 323 and the eighth opening 334.

In other words, the at least one light shielding layer is provided with a plurality of light directing channels corresponding to each micro lens in the micro lens array 310, and bottoms of the plurality of light directing channels corresponding to the each micro lens respectively extend below a plurality of adjacent micro lenses. In an example of the second micro lens 312, a plurality of light directing channels corresponding to the second micro lens 312 may include a light directing channel formed by the second opening 322 and the sixth opening 332 and a light directing channel formed by the third opening 323 and the ninth opening 335. The light directing channel formed by the second opening 322 and the sixth opening 332 extends below the first micro lens 311, and the light directing channel formed by the third opening 323 and the ninth opening 335 extends below the third micro lens 313. One optical sensing pixel may be disposed under each of a plurality of light directing channels corresponding to each micro lens in the micro lens array 310. In an example of the second micro lens 312, the second optical sensing pixel 342 is disposed under a light directing channel formed by the second opening 322 and the sixth opening 332, and the fifth optical sensing pixel 345 is disposed under a light directing channel formed by the third opening 323 and the ninth opening 335.

By properly designing a plurality of light directing channels corresponding to each micro lens, the optical sensing pixel array 340 may receive oblique light signals in multiple directions, and by converging the oblique light signals in multiple directions by a single micro lens, a problem that an exposure time for a solution of a single object space telecentric micro lens array is too long can be solved. In other words, the fingerprint detection apparatus 30 can not only solve a problem of a poor identification effect of vertical light signals on a dry finger and a problem of a too long exposure time for a solution of a single object space telecentric micro lens array, but also solve problems of excessive thickness, poor tolerance and excessive size.

It should be understood that the arrangement and size of the optical sensing pixel array are not specifically limited in the embodiment of the present application. For example, the fingerprint detecting unit may include a plurality of optical sensing pixels distributed in a polygon (such as a rhombus), a circle or an oval.

With continuing reference to FIG. 31, the fingerprint detection apparatus 30 may further include a transparent medium layer 350.

The transparent medium layer 350 may be disposed at least one of the following positions: a position between the micro lens array 310 and the at least one light shielding layer; a position between the at least one light shielding layer; and a position between the at least one light shielding layer and the optical sensing pixel array 340. For example, the transparent medium layer 350 may include a first medium layer 351 located between the micro lens array 310 and the at least one light shielding layer (that is, the first light shielding layer 320), and a second medium layer 352 between the first light shielding layer 320 and the second light shielding layer 330.

A material of the transparent medium layer 350 is any transparent material that is transparent to light, such as glass, or may be transitioned by air or vacuum, which is not specifically limited in the present application.

The structure of the fingerprint detecting unit or the fingerprint detection apparatus has been introduced above, such as a structure of a fingerprint detecting unit or a fingerprint detection apparatus constructed based on a transmission expect for light signals. However, in the process of manufacturing, mass production is required based on specific design parameters. Specific design parameters of a fingerprint detection apparatus will be exemplarily described below.

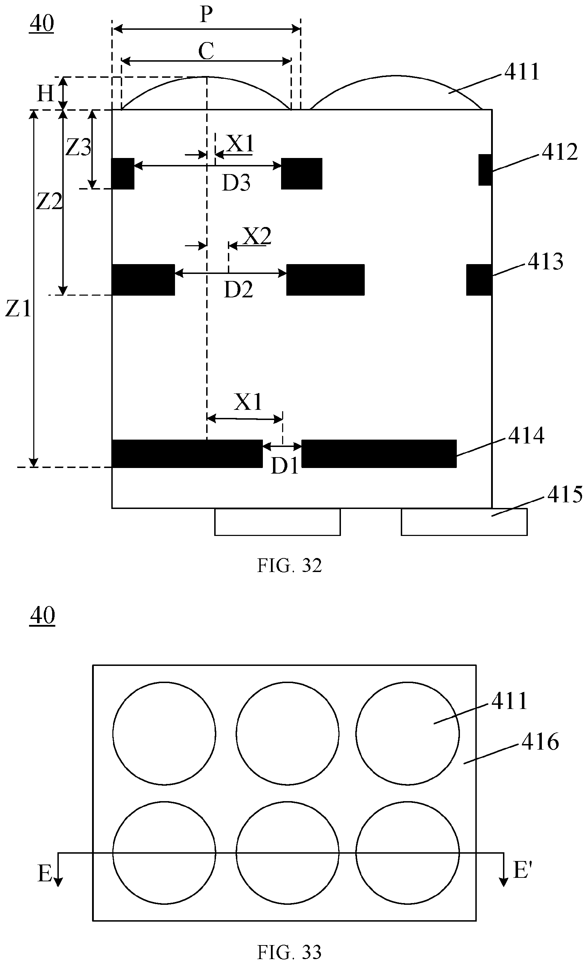

FIG. 32 is a schematic structural diagram of a fingerprint detection apparatus according to an embodiment of the present application. For ease of understanding, design parameters of the fingerprint detection apparatus will be described in the following with reference to FIG. 32.

As an example, the fingerprint detection apparatus includes: a micro lens array, Z light shielding layers located below the micro lens array, and an optical sensing pixel array located below the Z light shielding layers, where Z is a positive integer. The micro lens array is disposed below a display screen; the Z light shielding layers are disposed below the micro lens array, each of the Z light shielding layers being provided with an array of small holes; and the optical sensing pixel array is disposed below an array of small holes of a bottom light shielding layer of the Z light shielding layers.

It should be understood that the reference for the fingerprint detection apparatus and the micro lens array, the Z light shielding layers and the optical sensing pixel array in the fingerprint detection apparatus may be made to the related description in the above, which will not be described redundantly herein to avoid repetition.

As shown in FIG. 32, the micro lens array may include a plurality of micro lenses 411, the Z light shielding layers may include a top light shielding layer 412, a middle light shielding layer 413 and a bottom light shieling layer 414, and the optical sensing pixel array may include a plurality of optical sensing pixels 415. C represents a maximum caliber of a single micro lens, and if the micro lens is a micro lens in a square shape or another shape, C may be a maximum length of a cross section of the micro lens in a direction of period. P represents a period of a micro lens. H represents a height of a single micro lens, that is, a height from the top of the micro lens to the top of a flat layer. D₁, D₂ and D₃ respectively represent maximum apertures of small holes in the bottom light shielding layer 414, the middle light shielding layer 413 and the top light shielding layer 412, that is, a size of the largest caliber of an opening. X₁, X₂ and X₃ respectively represent offsets of center positions of openings in the bottom light shielding layer 414, the middle light shielding layer 413 and the top light shielding layer 412 from a center position of a corresponding micro lens on a plane where the micro lens array is located. Z₁, Z₂ and Z₃ respectively represent distances between the bottom light shielding layer 414, the middle light shielding layer 413 and the top light shielding layer 412 and a bottom (such as a lower surface) of the micro lens array.

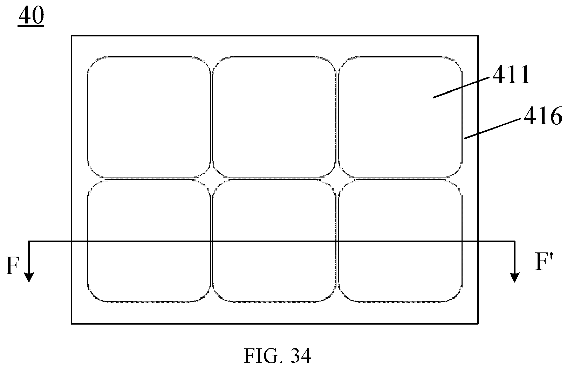

The micro lenses in the micro lens array may be circular micro lenses, that is, FIG. 32 may be a side cross-sectional view of a fingerprint detection apparatus 40 shown in FIG. 33 in an E-E' direction. The micro lenses in the micro lens array may also be square micro lenses. That is, FIG. 32 may be a side cross-sectional view of the fingerprint detection apparatus 40 shown in FIG. 34 in an F-F' direction. For example, the micro lenses in the micro lens array are circular micro lenses, a larger gap between adjacent circular micro lenses in the circular micro lens matrix results in a smaller ratio of an effective light-receiving area of the circular micro lens matrix, which is generally 60%; and the micro lenses in the square micro lens matrix may be obtained by cutting a sphere in a form of a cuboids, which can obtain a higher ratio of a light-receiving area (for example, above 98%) than the circular micro lens matrix. Certainly, in order to achieve a higher duty cycle, a single micro lens may also be in another shape.

The following is described by an example of the structure shown in FIG. 32 to design specific parameters of a fingerprint detection apparatus.

An array of small holes of each of the Z light shielding layers satisfies 0 ≤ *Xᵢ* / *Z_{d}* ≤ 3, such that a light signal returned from a finger above the display screen is transmitted to the optical sensing pixel array through arrays of small holes provided in the Z light shielding layers after being converged by the micro lens array, and the light signal is used to detect fingerprint information of the finger. *Z_{d}* represents a vertical distance between the bottom light shielding layer and the micro lens array, *Xᵢ* represents a distance between projections of a first center and a second center on a plane where the micro lens array is located, the first center is a center of a micro lens in the micro lens array, and the second center is a center of a small hole in the i-th light shielding layer of the Z light shielding layers for transmitting a light signal converged by the micro lens. For example, *Z_{d}* represents a vertical distance between a lower surface of the bottom light shielding layer and a lower surface of the micro lens array. For another example, *Z_{d}* represents a vertical distance between an upper surface of the bottom light shielding layer and a lower surface of the micro lens array. For example, the array of small holes of each of the Z light shielding layers satisfies 0 ≤ *Xᵢ* / *Z_{d}* ≤ 3/2. For another example, the array of small holes of each of the Z light shielding layers satisfies 1/2 ≤ *Xᵢ* / *Z_{d}* ≤ 3/2.

The i-th light shielding layer may be the i-th light shielding layer from top to bottom, or may be the i-th light shielding layer from bottom to top.

By restricting structure parameters of small holes in an array of small holes, aliasing of transmission of light signals returned via different positions of a finger could be avoided. That is, on the basis of a guarantee of contrast of a fingerprint image, brightness of the fingerprint image is improved, a signal-to-noise ratio and a resolution of the fingerprint image are increased, and a fingerprint identification effect and identification accuracy are improved.

It should be noted that a structure parameter *Xᵢ* / *Z_{d}* of a small hole in an array of small holes is a distance between the first center and the second center, which may be divided into three parameters in a spatial rectangular coordinate system. For example, a center position of each micro lens in the micro lens array may serve as an origin, a direction where rows of the micro lens array are located as an X axis, a direction where columns of the micro lens array are located as a Y axis, and a direction perpendicular to an X-Y plane as an Z axis. In this case, the parameter *Xᵢ* of the small hole may be replaced with a position of the small hole in an X-Y coordinate system, and the parameter *Z_{d}* of the small hole is replaced with a parameter of the small hole in the array of small holes in the Z-axis direction. For another example, a center position of the micro lens array may also serve as an origin to determine a spatial position of each small hole in the array of small holes.

It should also be noted that, regarding relevant parameters of a small hole in the array of small holes, since one micro lens may transmit converged light signals to a corresponding optical sensing pixel via a plurality of small holes, one micro lens may correspond to a plurality of parameters *Xᵢ* / *Z_{d}. In* addition, since a plurality of micro lenses may transmit converged light signals to corresponding optical sensing pixels via one small hole, similarly, one small hole may correspond to a plurality of parameters *Xᵢ* / *Z_{d}.* In other words, a spatial structure of one small hole may be designed by a plurality of parameters *Xᵢ* / *Z_{d}.*

In some embodiments of the present application, the maximum aperture of the small hole in the array of small holes of the bottom light shielding layer needs to be greater than a first preset value and less than a second preset value.

The small hole in the array of small holes of the bottom light shielding layer satisfies 0*um* < *D_{d}* ≤ 6*um*, where *D_{d}* represents a maximum aperture of the small hole in the array of small holes of the bottom light shielding layer. For example, the small hole in the array of small holes of the bottom light shielding layer satisfies 0.5*um* < *D_{d}* ≤ 5*um.* For another example, the small hole in the array of small holes of the bottom light shielding layer satisfies 0.4*um < D_{d}* ≤ 4*um.*

For a fingerprint image acquired through small hole imaging, the greater the contrast of the image is, the less the brightness (that is, an amount of light passing through a small hole) is. Correspondingly, the greater the brightness is, the less the contrast of the image is. In this embodiment, by restricting a maximum aperture of a small hole in an array of small holes, it can not only be guaranteed that each optical sensing pixel in an optical sensing pixel array can receive sufficient light signals, but also be guaranteed that an imaged image has sufficient brightness.

In some embodiments of the present application, each micro lens in the micro lens array may satisfy a formula 0 < *H* / *C* ≤ 1, where *H* represents a maximum thickness of a micro lens in the micro lens array, and *C* represents a maximum caliber of the micro lens in the micro lens array. For example, each micro lens in the micro lens array satisfies 0 < *H* / *C* ≤ 1/ 2 . For another example, each micro lens in the micro lens array satisfies 0.2 < *H l C* ≤ 0.4 .

The maximum caliber of the micro lens may be a maximum width of a cross section with the largest area of the micro lens. For example, the micro lens is a hemispherical lens, and the maximum caliber of the micro lens may be the maximum width of a plane of the hemispherical lens.

In other words, each micro lens in the micro lens array is a hemispherical micro lens, and a curvature of each micro lens in the micro lens array is less than or equal to 0.5.

When a fingerprint image is acquired through small hole imaging, it is necessary to guarantee that a spherical aberration of a micro lens in an micro lens array does not affect imaging quality. In this embodiment, by restricting a ratio of a maximum thickness of a micro lens to a maximum caliber of the micro lens, on the basis of miniaturization of a fingerprint detection apparatus, it can be guaranteed that the micro lens focuses a converged light signal in a small hole of a bottom light shielding layer, thereby guaranteeing imaging quality of a fingerprint image. In other words, by restricting a ratio of *H* to *C ,* on the basis of a guarantee that a fingerprint detection apparatus is thinner in thickness, a spherical aberration of the micro lens array is reduced, thereby guaranteeing a fingerprint identification effect.

In some embodiments of the present application, the bottom light shielding layer and the micro lens array satisfy 0*um* ≤ *Z_{d}* ≤ 100*um.* For example, the bottom light shielding layer and the micro lens array satisfy 2*um* ≤ *Z_{d}* ≤ 50*um.* For another example, the bottom light shielding layer and the micro lens array satisfy 3*um* ≤ *Z_{d}* ≤ 40*um.*

By restricting parameters of the bottom light shielding layer and the micro lens array, a thickness of the fingerprint detection apparatus can be effectively reduced. Certainly, a maximum distance or a minimum distance between each of the Z light shielding layers and the micro lens array may also be restricted. Both belong to the technical solutions protected by the embodiments of the present application.

In some embodiments of the present application, the micro lens array satisfies 0*um < P* ≤ 100*um*. For example, the micro lens array satisfies 2*um* ≤ *P* ≤ 50*um.* For another example, the micro lens array satisfies 1*um* ≤ *P* ≤ 40*um. P* represents a period of a micro lens in the micro lens array.

In other words, a distance between center positions of two adjacent micro lenses in the micro lens array satisfies 0*um < P* ≤ *100um,* that is, *P* may also be used to represent a distance between center positions of two adjacent micro lenses in the micro lens array.

By restricting a period of a micro lens array, not only is it convenient to produce the micro lens array separately, but also it is beneficial to spatially match an optical sensing pixel array, thereby acquiring an optical fingerprint image with a desired resolution.

In some embodiments of the present application, a small hole in the array of small holes of each of the Z light shielding layers and a micro lens in the micro lens array satisfy 0 < *Dᵢ* / *P* ≤ 3, where *Dᵢ* represents an aperture of a small hole in an array of small holes of the i-th light shielding layer of the Z light shielding layers, and *P* represents a period of the micro lens in the micro lens array. For example, the small hole in the array of small holes of each of the Z light shielding layers and the micro lens in the micro lens array satisfy 0 < *Dᵢ* / *P* ≤ 2. For another example, the small hole in the array of small holes of each of the Z light shielding layers and the micro lens in the micro lens array satisfy 1 < *Dᵢ* / *P* ≤ 4.

In other words, one small hole in the array of small holes in the fingerprint detection apparatus may correspond to one or more micro lenses. That is, one or more micro lenses may transmit light signals to a corresponding optical sensing pixel via one small hole in the array of small holes.

Regarding the array of small holes and the micro lens array distributed in an array, a design of light path parameters may be effectively simplified by the parameter *Dᵢ*/*P.*

In some embodiments of the present application, the micro lens array satisfies 0 < *C* / *P* ≤ 1, where *C* represents a maximum caliber of a micro lens in the micro lens array, and *P* represents a period of the micro lens in the micro lens array.

By restricting a ratio of *C* to *P* , a duty cycle of a micro lens array can be increased, thereby guaranteeing that the fingerprint detection apparatus is smaller in volume.

The Z light shielding layers satisfy 0 ≤ *Zᵢ* / *Z_{d}* ≤ 1, where *Zᵢ* represents a vertical distance between the i-th light shielding layer of the Z light shielding layers and the micro lens array, and *Z_{d}* represents a vertical distance between the bottom light shielding layer and the micro lens array. For example, the Z light shielding layers satisfy 0 ≤ *Zᵢ* / *Z_{d}* ≤ 0.5 .

In other words, by specifying the parameter *Zᵢ* / *Z_{d} ,* design parameters of the Z light shielding layers can be simplified so as to improve installation efficiency of the Z light shielding layers during the mass production.

The followings are examples of specific values for the foregoing parameters.

**Table 1**

| Parameter | Example one | Example two | Example three | Example four | Example five | Example six | Example seven | Example eight | Example nine |
|---|---|---|---|---|---|---|---|---|---|
| P | 16.88 | 10.45 | 22.50 | 8.75 | 7.86 | 18.14 | 12.50 | 13.63 | 11.50 |
| C | 15.53 | 9.61 | 22.50 | 8.75 | 7.86 | 16.68 | 9.09 | 12.54 | 10.58 |
| H | 4.37 | 1.71 | 6.55 | 2.76 | 3.17 | 3.63 | 2.06 | 1.96 | 2.47 |
| D1 | 1.38 | 2.17 | 5.30 | 1.62 | 1.59 | 4.30 | 2.59 | 2.41 | 1.71 |
| D2 | 13.51 | 4.01 | 7.47 | 3.12 | 4.09 | 6.50 | 5.81 | 7.97 | 12.22 |
| D3 | None | 9.44 | None | None | None | 17.33 | None | 13.47 | None |
| X1 | 0.00 | 0.00 | 0.00 | 0.00 | 11.91 | 10.68 | 9.13 | 8.64 | 8.19 |
| X2 | 0.00 | 0.00 | 0.00 | 0.00 | 9.93 | 6.85 | 3.10 | 3.40 | 2.79 |
| X3 | None | 0.00 | None | None | None | 0.00 | None | 2.00 | None |
| Z1 | 18.13 | 19.90 | 27.34 | 11.79 | 12.78 | 25.43 | 21.45 | 23.74 | 22.20 |
| Z2 | 1.79 | 16.25 | 15.44 | 8.41 | 7.74 | 20.90 | 13.30 | 15.24 | 14.99 |
| Z3 | None | 0.75 | None | None | None | 1.72 | None | 10.86 | None |

As shown in Table 1, the fingerprint detection apparatus may be provided with two light shielding layers (that is, light shielding layers related to Z1 and Z2), or may be provided with three light shielding layers (that is, light shielding layers related to Z1, Z2 and Z3). Certainly, the number of light shielding layers provided may also be one or greater than three, which is not specifically limited in the present application.

Based on values of the parameters in Table 1, Table 2 exemplarily provides structure parameters of the fingerprint detection apparatus designed by a ratio of two parameters.

**Table 2**

| Parameter | Example one | Example two | Example three | Example four | Example five | Example six | Example seven | Example eight | Example nine |
|---|---|---|---|---|---|---|---|---|---|
| P | 16.88 | 10.45 | 22.50 | 8.75 | 7.86 | 18.14 | 12.50 | 13.63 | 11.50 |
| Z1 | 18.13 | 19.90 | 27.34 | 11.79 | 12.78 | 25.43 | 21.45 | 23.74 | 22.20 |
| D1 | 1.38 | 2.17 | 5.30 | 1.62 | 1.59 | 4.30 | 2.59 | 2.41 | 1.71 |
| H/C | 0.28 | 0.18 | 0.29 | 0.31 | 0.40 | 0.22 | 0.23 | 0.16 | 0.23 |
| C/P | 0.92 | 0.92 | 1.00 | 1.00 | 1.00 | 0.92 | 0.73 | 0.92 | 0.92 |
| D1/P | 0.08 | 0.21 | 0.24 | 0.18 | 0.20 | 0.24 | 0.21 | 0.18 | 0.15 |
| D2/P | 0.80 | 0.38 | 0.33 | 0.36 | 0.52 | 0.36 | 0.46 | 0.59 | 1.06 |
| D3/P | None | 0.90 | None | None | None | 0.96 | None | 0.99 | None |
| X1/Z1 | 0.00 | 0.00 | 0.00 | 0.00 | 0.93 | 0.42 | 0.43 | 0.36 | 0.37 |
| X2/Z1 | 0.00 | 0.00 | 0.00 | 0.00 | 0.78 | 0.27 | 0.14 | 0.14 | 0.13 |
| X3/Z1 | None | 0.00 | None | None | None | 0.00 | None | 0.08 | None |
| Z1/Z1 | 1.00 | 1.00 | 1.00 | 1.00 | 1.00 | 1.00 | 1.00 | 1.00 | 1.00 |
| Z2/Z1 | 0.10 | 0.82 | 0.56 | 0.71 | 0.61 | 0.82 | 0.62 | 0.64 | 0.68 |
| Z3/Z1 | None | 0.04 | None | None | None | 0.07 | None | 0.46 | None |

As shown in Table 2, the ratio of two parameters involved in the above may also be used to design the structure of the fingerprint detection apparatus. It should be noted that the embodiments of the present application are not limited to the foregoing specific values, and those skilled in the art may determine specific values of various parameters according to actual light path design requirements. For example, the foregoing parameters may be accurate to three or four decimal places.

It should be understood that the foregoing drawings are only examples of the present application and should not be understood as limitation to the present application.

For example, in some embodiments of the present application, the fingerprint identification apparatus further includes a filter layer. The filter layer is disposed in a light path between the micro lens array and the optical sensing pixel array or disposed above the micro lens array, and the filter layer is used to filter out a light signal in a non-target wave band to transmit a light signal in a target wave band.

For example, the filter layer may be a polarizer, a color filter plate, an infrared filter plate, or the like, to achieve the function, such as selection of polarization, or selection of a specific spectrum.

For another example, transmittance of the filter layer to light in a target wave band may be greater than or equal to a preset threshold, and a cutoff rate of the filter layer to light in a non-target wave band may be greater than or equal to the preset threshold. For example, the preset threshold may be 80%. Optionally, the filter layer may be a filter layer independently provided. For example, the filter layer may be a filter layer formed by using blue crystal or blue glass as a carrier. Optionally, the filter layer may be a coating film provided on a surface of any layer in the light path. For example, a coating film may be provided on a surface of the optical sensing pixel, a surface of any one of the transparent medium layers or a surface of the micro lens so as to form the filter layer.

The preferred embodiments of the present application are described in detail above with reference to the accompanying drawings. However, the present application is not limited to specific details in the foregoing embodiments. Within the technical concept of the present application, a variety of simple variants may be carried out on the technical solution of the present application, and all of the simple variants are within the protection scope of the present application.

For example, various specific technical features described in the foregoing specific embodiments may be combined in any suitable manner under the condition of no contradiction. In order to avoid unnecessary repetition, various possible combination ways will not be separately described in the present application.

For another example, any combination may be made between various embodiments of the present application without departing from the idea of the present application, and it should also be regarded as the disclosure of the present application.

It should be understood that sequence numbers of the foregoing processes do not mean execution sequences in various method embodiments of the present application. The execution sequences of the processes should be determined according to functions and internal logic of the processes, and should not be construed as any limitation on the implementation processes of the embodiments of the present application.

An embodiment of the present application further provides an electronic device, and the electronic device may include a display screen and the fingerprint detection apparatus according to the foregoing embodiments of the present application, where the fingerprint detection apparatus is disposed below the display screen to implement under-screen optical fingerprint detection.

The electronic device may be any electronic device having a display screen. For example, the electronic device may be the electronic device 10 shown in FIG. 1 to FIG. 4.

The display screen may use the display screen in the above description, such as an OLED display screen or other display screens. For a description of the display screen, reference may be made to illustration of the display screen in the above description, and for brevity, no further details are provided herein.

It should be understood that specific examples in embodiments of the present application are just for helping those skilled in the art better understand the embodiments of the present application, rather than for limiting the scope of the embodiments of the present application.

It should be understood that terms used in embodiments of the present application and the claims appended hereto are merely for the purpose of describing particular embodiments, and are not intended to limit the embodiments of the present application. For example, the use of a singular form of "a", "the above" and "said" in the embodiments of the present application and the claims appended hereto are also intended to include a plural form, unless otherwise clearly indicated herein by context.

Those of ordinary skill in the art may be aware that, units of the examples described in the embodiments disclosed in this paper may be implemented by electronic hardware, computer software, or a combination of the two. To clearly illustrate interchangeability between the hardware and the software, the foregoing illustration has generally described composition and steps of the examples according to functions. Whether these functions are performed by hardware or software depends on particular applications and designed constraint conditions of the technical solutions. Persons skilled in the art may use different methods to implement the described functions for each particular application, but it should not be considered that the implementation goes beyond the scope of the present application.

If the integrated unit is implemented in the form of the software functional unit and is sold or used as an independent product, it may be stored in a computer readable storage medium. Based on such understanding, the nature of the technical solutions of the present application, or the part contributing to the prior art, or all of or part of the technical solutions may be implemented in a form of software product. The computer software product is stored in a storage medium and includes several instructions for instructing a computer device (which may be a personal computer, a server, a network device, or the like) to execute all of or part of the steps of the method described in the embodiments of the present application. The storage medium includes: various media that may store program codes, such as a U-disk, a removable hard disk, a read-only memory (ROM), a random access memory (RAM), a magnetic disk, a compact disk, and so on.

The protection scope of the present application shall be subject to the protection scope of the appended claims.

## Claims

1. A fingerprint detection apparatus, wherein the fingerprint detection apparatus is applied below a display screen (216) to implement under-screen optical fingerprint detection, and the fingerprint detection apparatus comprises:
a micro lens array (310) disposed below the display screen (216), wherein the micro lens array (310) comprises a rectangular array of 2×2 micro lenses, the plurality of optical sensing pixels are a rectangular array of 2×2 optical sensing pixels, and one micro lens is disposed right above each optical sensing pixel in the rectangular array of 2×2 optical sensing pixel, wherein the micro lens (212) at the upper right corner of the array converges the received oblique light signals to the optical sensing pixel (211) at the upper left corner, the micro lens (212) at the upper left corner of the array converges the received oblique light signals to the optical sensing pixel (211) at the lower left corner, the micro lens (212) at the lower left corner of the array converges the received oblique light signals to the optical sensing pixel (211) at the lower right corner, and the micro lens (212) at the lower right corner of the array converges the received oblique light signals to the optical sensing pixel (211) at the upper right corner;
Z light shielding layers disposed below the micro lens array (310), each of the Z light shielding layers being provided with an array of small holes, wherein Z is a positive integer; and
an optical sensing pixel array (340) disposed below an array of small holes of a bottom light shielding layer of the Z light shielding layers;
wherein the array of small holes of each of the Z light shielding layers satisfies 0 ≤ *Xᵢ* / *Z_{d}* ≤ 3, such that a light signal returned from a finger above the display screen (216) is transmitted to the optical sensing pixel array (340) through arrays of small holes provided in the Z light shielding layers after being converged by the micro lens array (310), and the light signal is used to detect fingerprint information of the finger;
*Z_{d}* represents a vertical distance between the bottom light shielding layer and the micro lens array (310), *Xᵢ* represents a distance between projections of a first center and a second center on a plane where the micro lens array (310) is located, the first center is a center of a micro lens (222) in the micro lens array (310), and the second center is a center of a small hole in the i-th light shielding layer of the Z light shielding layers for transmitting a light signal converged by the micro lens (222);
the Z light shielding layers satisfy 0 ≤ *Zᵢ* / *Z_{d}* ≤ 1 , where *Zᵢ* represents a vertical distance between the i-th light shielding layer of the Z light shielding layers and the micro lens array (310); and
a metal wiring layer of the optical sensing pixel array is disposed at a position of a back focal plane of the micro lens array, and the metal wiring layer is provided with one opening formed above each optical sensing pixel in the optical sensing pixel array (340) to form the bottom light shielding layer, the small hole in the array of small holes of the bottom light shielding layer satisfies 0*um* < *D_{d}* ≤ 6*um* , wherein *D_{d}* represents a maximum aperture of the small hole in the array of small holes of the bottom light shielding layer.

2. The fingerprint detection apparatus according to claim 1, wherein the array of small holes of each of the Z light shielding layers satisfies 0 ≤ *Xᵢ* / *Z_{d}* ≤ 3 / 2 .

3. The fingerprint detection apparatus according to claim 1 or 2, a small hole in the array of small holes of the bottom light shielding layer satisfies 0.5wm < *D_{d}* ≤ 5*um.*

4. The fingerprint detection apparatus according to any one of claims 1 to 3, wherein each micro lens (222) in the micro lens array (310) satisfies 0 < *H* / *C* ≤ 1/2, wherein *H* represents a maximum thickness of a micro lens in the micro lens array, and *C* represents a maximum caliber of the micro lens in the micro lens array.

5. The fingerprint detection apparatus according to any one of claims 1 to 4, wherein the vertical distance between the bottom light shielding layer and the micro lens array (310) satisfy 0*um* ≤ *Z_{d}* ≤ 100*um.*

6. The fingerprint detection apparatus according to claim 5, wherein the vertical distance between the bottom light shielding layer and the micro lens array (310) satisfy *2um* ≤ *Z_{d}* ≤ 50*um.*

7. The fingerprint detection apparatus according to any one of claims 1 to 6, wherein the micro lens array (310) satisfies 0*um* < *P* ≤ 100*um ,* and *P* represents a period of a micro lens (222) in the micro lens array (310).

8. The fingerprint detection apparatus according to claim 7, wherein the micro lens array (310) satisfies *2um* ≤ *P* ≤ 50*um.*

9. The fingerprint detection apparatus according to any one of claims 1 to 8, wherein a small hole in the array of small holes of each of the Z light shielding layers and a micro lens (222) in the micro lens array (310) satisfy 0 < *Dᵢ* / *P* ≤ 3, wherein *Dᵢ* represents an aperture of a small hole in an array of small holes of the i-th light shielding layer of the Z light shielding layers, and *P* represents a period of the micro lens (222) in the micro lens array (310).

10. The fingerprint detection apparatus according to claim 9, wherein the small hole in the array of small holes of each of the Z light shielding layers and the micro lens (222) in the micro lens array (310) satisfy 0 < *Dᵢ* / *P* ≤ 2.

11. The fingerprint detection apparatus according to any one of claims 1 to 10, wherein the Z light shielding layers are a plurality of light shielding layers, and apertures of openings in the plurality of light shielding layers corresponding to a same optical sensing pixel decrease in order from top to bottom.

12. The fingerprint detection apparatus according to claim 11, wherein one opening in an array of small holes of a top light shielding layer (412) of the plurality of light shielding layers corresponds to one or more optical sensing pixels in the optical sensing pixel array (340).

13. The fingerprint detection apparatus according to any one of claims 1 to 12, wherein the fingerprint detection apparatus further comprises:
a transparent medium layer (350);
wherein the transparent medium layer (350) is used to connect the micro lens array (310), the Z light shielding layers and the optical sensing pixel array (340).

14. The fingerprint detection apparatus according to any one of claims 1 to 13, wherein the fingerprint detection apparatus further comprises:
a filter layer;
wherein the filter layer is disposed in a light path between the micro lens array (310) and the optical sensing pixel array (340) or disposed above the micro lens array (310), and the filter layer is used to filter out a light signal in a non-target wave band to transmit a light signal in a target wave band.

15. An electronic device, wherein the electronic device comprises:
a display screen (216); and
the fingerprint detection apparatus according to any one of claims 1 to 14, wherein the apparatus is disposed below the display screen (216) to implement under-screen optical fingerprint detection.

## Patentansprüche

1. Fingerabdruck-Erkennungsgerät, wobei das Fingerabdruck-Erkennungsgerät unter einem Anzeigebildschirm (216) angebracht wird, um optische Fingerabdruckerkennung unter dem Bildschirm zu implementieren, und das Fingerabdruck-Erkennungsgerät umfasst:
eine Mikrolinsenmatrix (310), die unter dem Anzeigebildschirm (216) angeordnet ist, wobei die Mikrolinsenmatrix (310) eine rechteckige Matrix von 2x2 Mikrolinsen umfasst, die Vielzahl der optischen Abtastpixel eine rechteckige Matrix von 2x2 optischen Abtastpixeln ist, und eine Mikrolinse direkt oberhalb jedes optischen Abtastpixels in der rechteckigen Matrix von 2x2 optischen Abtastpixeln angeordnet ist, wobei die Mikrolinse (212) an der oberen rechten Ecke der Matrix die empfangenen schrägen Lichtsignale zu dem optischen Abtastpixel (211) an der oberen linken Ecke konvergiert, die Mikrolinse (212) an der oberen linken Ecke der Matrix die empfangenen schrägen Lichtsignale zu dem optischen Abtastpixel (211) an der unteren linken Ecke konvergiert, die Mikrolinse (212) an der unteren linken Ecke der Matrix die empfangenen schrägen Lichtsignale zu dem optischen Abtastpixel (211) an der unteren rechten Ecke konvergiert, und die Mikrolinse (212) an der unteren rechten Ecke der Matrix die empfangenen schrägen Lichtsignale zu dem optischen Abtastpixel (211) an der oberen rechten Ecke konvergiert;
Z Lichtabschirmschichten unterhalb der Mikrolinsenmatrix (310) angeordnet sind, wobei jede der Z Lichtabschirmschichten mit einer Matrix aus kleinen Löchern ausgestattet ist, wobei Z eine positive ganze Zahl ist; und
eine optische Abtastpixelmatrix (340) unter einer Matrix aus kleinen Löchern einer unteren Lichtabschirmschicht der Z Lichtabschirmschichten angeordnet ist;
wobei die Matrix aus kleinen Löchern von jeder der Z Lichtabschirmschichten 0 ≤ X_{i/}Z_{d} ≤ 3 erfüllt, so dass ein Lichtsignal, das von einem Finger oberhalb des Anzeigebildschirms (216) zurückkehrt, durch Matrizes aus kleinen Löchern, die in den Z Lichtabschirmschichten bereitgestellt sind, an die optische Abtastpixelmatrix (340) übertragen wird, nachdem die Konvergierung durch die Mikrolinsenmatrix (310) erfolgt ist, und das Lichtsignal verwendet wird, um Fingerabdruckinformationen des Fingers zu erkennen;
Z_{d} einen vertikalen Abstand zwischen der unteren Lichtabschirmschicht und der Mikrolinsenmatrix (310) repräsentiert, Xᵢ einen Abstand zwischen Projektionen eines ersten Zentrums und eines zweiten Zentrums auf einer Ebene repräsentiert, in der sich die Mikrolinsenmatrix (310) befindet, wobei das erste Zentrum ein Zentrum einer Mikrolinse (222) in der Mikrolinsenmatrix (310) ist, und das zweite Zentrum ein Zentrum eines kleinen Loches in der i. Lichtabschirmschicht der Z Lichtabschirmschichten zum Übertragen eines Lichtsignals ist, das durch die Mikrolinse (222) konvergiert worden ist;
die Z Lichtabschirmschichten 0 ≤ Zᵢ/Z_{d} ≤ 1 erfüllen, wobei Zᵢ einen vertikalen Abstand zwischen der i. Lichtabschirmschicht der Z Lichtabschirmschichten und der Mikrolinsenmatrix (310) repräsentiert; und
eine Metallverdrahtungsschicht der optischen Abtastpixelmatrix an einer Position einer hinteren Fokalebene der Mikrolinsenmatrix angeordnet ist, und die Metallverdrahtungsschicht mit einer Öffnung ausgestattet ist, die oberhalb jedes optischen Abtastpixels in der optischen Abtastpixelmatrix (340) gebildet ist, um die untere Lichtabschirmschicht zu bilden, wobei das kleine Loch in der Matrix aus kleinen Löchern der unteren Lichtabschirmschicht 0 µm < D_{d} ≤ 6 µm erfüllt, wobei D_{d} eine maximale Blende des kleinen Loches in der Matrix aus kleinen Löchern der unteren Lichtabschirmschicht repräsentiert.

2. Fingerabdruck-Erkennungsgerät nach Anspruch 1, wobei die Matrix aus kleinen Löchern von jeder der Z Lichtabschirmschichten 0 ≤ Xᵢ/Z_{d}≤ 3/2 erfüllt.

3. Fingerabdruck-Erkennungsgerät nach Anspruch 1 oder 2, wobei ein kleines Loch in der Matrix aus kleinen Löchern der unteren Lichtabschirmschicht 0,5 µm ≤ D_{d} ≤ 5 µm erfüllt.

4. Fingerabdruck-Erkennungsgerät nach einem der Ansprüche 1 bis 3, wobei jede Mikrolinse (222) in der Mikrolinsenmatrix (310) 0 < H/C ≤ 1/2 erfüllt, wobei H eine maximale Dicke einer Mikrolinse in der Mikrolinsenmatrix repräsentiert, und C ein Maximalkaliber der Mikrolinse in der Mikrolinsenmatrix repräsentiert.

5. Fingerabdruck-Erkennungsgerät nach einem der Ansprüche 1 bis 4, wobei der vertikale Abstand zwischen der unteren Lichtabschirmschicht und der Mikrolinsenmatrix (310) 0 µm ≤ Z_{d} ≤ 100 µm erfüllt.

6. Fingerabdruck-Erkennungsgerät nach Anspruch 5, wobei der vertikale Abstand zwischen der unteren Lichtabschirmschicht und der Mikrolinsenmatrix (310) 2 µm ≤ Z_{d} ≤ 50 µm erfüllt.

7. Fingerabdruck-Erkennungsgerät nach einem der Ansprüche 1 bis 6, wobei die Mikrolinsenmatrix (310) 0 µm < P ≤ 100 µm erfüllt, und P eine Periode einer Mikrolinse (222) in der Mikrolinsenmatrix (310) repräsentiert.

8. Fingerabdruck-Erkennungsgerät nach Anspruch 7, wobei die Mikrolinsenmatrix (310) 2 µm ≤ P ≤ 50 µm erfüllt.

9. Fingerabdruck-Erkennungsgerät nach einem der Ansprüche 1 bis 8, wobei ein kleines Loch in der Matrix aus kleinen Löchern von jeder der Z Lichtabschirmschichten und eine Mikrolinse (222) in der Mikrolinsenmatrix (310) 0 < Dᵢ/P ≤ 3 erfüllen, wobei Dᵢ eine Blende eines kleinen Loches in einer Matrix aus kleinen Löchern der i. Lichtabschirmschicht der Z Lichtabschirmschichten repräsentiert, und P eine Periode der Mikrolinse (222) in der Mikrolinsenmatrix (310) repräsentiert.

10. Fingerabdruck-Erkennungsgerät nach Anspruch 9, wobei das kleine Loch in der Matrix aus kleinen Löchern von jeder der Z Lichtabschirmschichten und die Mikrolinse (222) in der Mikrolinsenmatrix (310) 0 < D_{i/}P ≤ 2 erfüllen.

11. Fingerabdruck-Erkennungsgerät nach einem der Ansprüche 1 bis 10, wobei die Z Lichtabschirmschichten eine Vielzahl von Lichtabschirmschichten sind, und Blenden von Öffnungen in der Vielzahl der Lichtabschirmschichten der gleichen optischen Abtastpixelabnahme in der Reihenfolge von oben nach unten entsprechen.

12. Fingerabdruck-Erkennungsgerät nach Anspruch 11, wobei eine Öffnung in einer Matrix aus kleinen Löchern einer oberen Lichtabschirmschicht (412) der Vielzahl von Lichtabschirmschichten einem oder mehreren optischen Abtastpixeln in der optischen Abtastpixelmatrix (340) entspricht.

13. Fingerabdruck-Erkennungsgerät nach einem der Ansprüche 1 bis 12, wobei das Fingerabdruck-Erkennungsgerät des Weiteren umfasst:
eine transparente Mediumschicht (350);
wobei die transparente Mediumschicht (350) verwendet wird, um die Mikrolinsenmatrix (310), die Z Lichtabschirmschichten und die optische Abtastpixelmatrix (340) zu verbinden.

14. Fingerabdruck-Erkennungsgerät nach einem der Ansprüche 1 bis 13, wobei das Fingerabdruck-Erkennungsgerät des Weiteren umfasst:
eine Filterschicht;
wobei die Filterschicht in einem Lichtpfad zwischen der Mikrolinsenmatrix (310) und der optischen Abtastpixelmatrix (340) angeordnet ist, oder oberhalb der Mikrolinsenmatrix (310) angeordnet ist, und die Filterschicht verwendet wird, um ein Lichtsignal in einem Nicht-Zielwellenband auszufiltern, um ein Lichtsignal in einem Zielwellenband zu übertragen.

15. Elektronische Vorrichtung, wobei die elektronische Vorrichtung umfasst:
ein Anzeigebildschirm (216); und
ein Fingerabdruck-Erkennungsgerät nach einem der Ansprüche 1 bis 14, wobei das Gerät unterhalb des Anzeigebildschirms (216) angeordnet ist, um optische Fingerabdruckerkennung unter dem Bildschirm zu implementieren.

## Revendications

1. Appareil de détection d'empreinte, l'appareil de détection d'empreinte étant appliqué au-dessous d'un écran d'affichage (216) pour mettre en oeuvre une détection d'empreinte optique sous écran, et l'appareil de détection d'empreinte comprenant :
un réseau de microlentilles (310) disposé au-dessous de l'écran d'affichage (216), le réseau de microlentilles (310) comprenant un réseau rectangulaire de 2×2 microlentilles, la pluralité de pixels de détection optique étant un réseau rectangulaire de 2×2 pixels de détection optique, et une microlentille étant disposée juste au-dessus de chaque pixel de détection optique dans le réseau rectangulaire de 2×2 pixels de détection optique, la microlentille (212) au coin supérieur droit du réseau faisant converger les signaux lumineux obliques reçus sur le pixel de détection optique (211) au coin supérieur gauche, la microlentille (212) au coin supérieur gauche du réseau faisant converger les signaux lumineux obliques reçus sur le pixel de détection optique (211) au coin inférieur gauche, la microlentille (212) au coin inférieur gauche du réseau faisant converger les signaux lumineux obliques reçus sur le pixel de détection optique (211) au coin inférieur droit, et la microlentille (212) au coin inférieur droit du réseau faisant converger les signaux lumineux obliques reçus sur le pixel de détection optique (211) au coin supérieur droit ;
Z couches faisant écran à la lumière disposées au-dessus du réseau de microlentilles (310), chacune des Z couches faisant écran à la lumière étant pourvue d'un réseau de petits trous, Z étant un entier positif ; et
un réseau de pixels de détection optique (340) disposé au-dessous d'un réseau de petits trous d'une couche faisant écran à la lumière inférieure des Z couches faisant écran à la lumière ;
dans lequel le réseau de petits trous de chacune des Z couches faisant écran à la lumière satisfait 0 ≤ *Xᵢ*/*Z_{d}* ≤ 3, de telle sorte qu'un signal lumineux retourné depuis un doigt au-dessus de l'écran d'affichage (216) est transmis au réseau de pixels de détection optique (340) par le biais de réseaux de petits trous disposés dans les Z couches faisant écran à la lumière après que le réseau de microlentilles (310) l'a fait converger, et le signal lumineux est utilisé pour détecter des informations d'empreinte du doigt ;
*Z_{d}* représente une distance verticale entre la couche faisant écran à la lumière inférieure et le réseau de microlentilles (310), *Xᵢ* représente une distance entre des projections d'un premier centre et d'un deuxième centre sur un plan où se situe le réseau de microlentilles (310), le premier centre est un centre d'une microlentille (222) dans le réseau de microlentilles (310), et le deuxième centre est un centre d'un petit trou dans la i^{ième} couche faisant écran à la lumière des Z couches faisant écran à la lumière pour transmettre un signal lumineux que la microlentille (222) a fait converger ;
les Z couches faisant écran à la lumière satisfont 0 ≤ *Zᵢ*/*Z_{d}* ≤ 1, où *Zᵢ* représente une distance verticale entre la i^{ième} couche faisant écran à la lumière des Z couches faisant écran à la lumière et le réseau de microlentilles (310) ; et
une couche de câblage métallique du réseau de pixels de détection optique est disposée à une position d'un plan focal arrière du réseau de microlentilles, et la couche de câblage métallique est pourvue d'un orifice formé au-dessus de chaque pixel de détection optique dans le réseau de pixels de détection optique (340) pour former la couche faisant écran à la lumière inférieure, le petit trou dans le réseau de petits trous de la couche faisant écran à la lumière inférieure satisfait 0 µm < *D_{d}* ≤ 6 µm, dans lequel *D_{d}* représente une ouverture maximale du petit trou dans le réseau de petits trous de la couche faisant écran à la lumière inférieure.

2. Appareil de détection d'empreinte selon la revendication 1, dans lequel le réseau de petits trous de chacune des Z couches faisant écran à la lumière satisfait 0 ≤ *Xᵢ*/*Z_{d}* ≤ 3/2.

3. Appareil de détection d'empreinte selon la revendication 1 ou 2, dans lequel un petit trou dans le réseau de petits trous de la couche faisant écran à la lumière inférieure satisfait 0,5 µm < *D_{d}* ≤ 5 µm.

4. Appareil de détection d'empreinte selon l'une quelconque des revendications 1 à 3, dans lequel chaque microlentille (222) dans le réseau de microlentilles (310) satisfait 0 < *H*/*C* ≤ 1/2, dans lequel *H* représente une épaisseur maximale d'une microlentille dans le réseau de microlentilles, et C représente un calibre maximal de la microlentille dans le réseau de microlentilles.

5. Appareil de détection d'empreinte selon l'une quelconque des revendications 1 à 4, dans lequel la distance verticale entre la couche faisant écran à la lumière inférieure et le réseau de microlentilles (310) satisfait 0 µm ≤ *Z_{d}* ≤ 100 µm.

6. Appareil de détection d'empreinte selon la revendication 5, dans lequel la distance verticale entre la couche faisant écran à la lumière inférieure et le réseau de microlentilles (310) satisfait 2 µm ≤ *Z_{d}* ≤ 50 µm.

7. Appareil de détection d'empreinte selon l'une quelconque des revendications 1 à 6, dans lequel le réseau de microlentilles (310) satisfait 0 µm < *P* ≤ 100 µm, et P représente une période d'une microlentille (222) dans le réseau de microlentilles (310).

8. Appareil de détection d'empreinte selon la revendication 7, dans lequel le réseau de microlentilles (310) satisfait 2 µm < *P* ≤ 50 µm.

9. Appareil de détection d'empreinte selon l'une quelconque des revendications 1 à 8, dans lequel un petit trou dans le réseau de petits trous de chacune des Z couches faisant écran à la lumière et une microlentille (222) dans le réseau de microlentilles (310) satisfont 0 *< Dᵢ*/*P* ≤ 3, dans lequel *Dᵢ* représente une ouverture d'un petit trou dans un réseau de petits trous de la i^{ième} couche faisant écran à la lumière des Z couches faisant écran à la lumière, et P représente une période de la microlentille (222) dans le réseau de microlentilles (310).

10. Appareil de détection d'empreinte selon la revendication 9, dans lequel le petit trou dans le réseau de petits trous de chacune des Z couches faisant écran à la lumière et la microlentille (222) dans le réseau de microlentilles (310) satisfont 0 < *Dᵢ*/*P* ≤ 2.

11. Appareil de détection d'empreinte selon l'une quelconque des revendications 1 à 10, dans lequel les Z couches faisant écran à la lumière sont une pluralité de couches faisant écran à la lumière, et des ouvertures d'orifices dans la pluralité de couches faisant écran à la lumière correspondant à un même pixel de détection optique diminuent dans l'ordre de haut en bas.

12. Appareil de détection d'empreinte selon la revendication 11, dans lequel un orifice dans un réseau de petits trous d'une couche faisant écran à la lumière supérieure (412) de la pluralité de couches faisant écran à la lumière correspond à un ou plusieurs pixels de détection optique dans le réseau de pixels de détection optique (340).

13. Appareil de détection d'empreinte selon l'une quelconque des revendications 1 à 12, l'appareil de détection d'empreinte comprenant en outre :
une couche de milieu transparent (350) ;
dans lequel la couche de milieu transparent (350) est utilisée pour connecter le réseau de microlentilles (310), les Z couches faisant écran à la lumière et le réseau de pixels de détection optique (340).

14. Appareil de détection d'empreinte selon l'une quelconque des revendications 1 à 13, l'appareil de détection d'empreinte comprenant en outre :
une couche de filtre ;
dans lequel la couche de filtre est disposée sur un chemin lumineux entre le réseau de microlentilles (310) et le réseau de pixels de détection optique (340) ou disposée au-dessus du réseau de microlentilles (310), et la couche de filtre est utilisée pour éliminer par filtrage un signal lumineux dans une bande d'ondes non cibles pour transmettre un signal lumineux dans une bande d'ondes cibles.

15. Dispositif électronique, le dispositif électronique comprenant :
un écran d'affichage (216) ; et
l'appareil de détection d'empreinte selon l'une quelconque des revendications 1 à 14, dans lequel l'appareil est disposé au-dessous de l'écran d'affichage (216) pour mettre en oeuvre une détection d'empreinte optique sous écran.
